# EUROPEAN PATENT APPLICATION

(11) **EP 4 770 306 A1**
(43) Date of publication of application: **01.07.2026**
(21) Application number: 25221433.3
(22) Date of filing: 08.12.2025
(51) Int. Cl.: H10B 12/00, G11C 11/405, H10D 30/67

(54) **SEMICONDUCTOR DEVICE COMPRISING A 2-TRANSISTOR (2T) MEMORY CELL AND METHOD OF MANUFACTURING THE SAME**

(30) Priority: 24.12.2024 KR 20240195251
(71) Applicant: Samsung Electronics Co., Ltd., Suwon-si, Gyeonggi-do 16677 (KR)
(72) Inventor: KANG, Sujin, 16677 Suwon-si, Gyeonggi-do (KR); CHAE, Heejae, 16677 Suwon-si, Gyeonggi-do (KR); CHA, Inho, 16677 Suwon-si, Gyeonggi-do (KR); LEE, Hyunjin, 16677 Suwon-si, Gyeonggi-do (KR); KIM, Huijung, 16677 Suwon-si, Gyeonggi-do (KR); KIM, Yongkwan, 16677 Suwon-si, Gyeonggi-do (KR); KIM, Seunghoon, 16677 Suwon-si, Gyeonggi-do (KR); KIM, Minsoo, 16677 Suwon-si, Gyeonggi-do (KR); KANG, Minju, 16677 Suwon-si, Gyeonggi-do (KR)
(74) Representative: Kuhnen & Wacker Patent- und Rechtsanwaltsbüro PartG mbB

(57) **Abstract**

A semiconductor device includes a bit line (BL) extending in a vertical direction (Z), and a 2-transistor, 2T, memory cell (MC1, MC2) including a first transistor (T1) and a second transistor (T2) on the first transistor (T1). The first transistor (T1) includes an active pattern (120) contacting the bit line (BL), the active pattern (120) including a first and second source/drain region (SD1, SD2), and a channel region (CH), and a first gate structure (GS1) including a first gate electrode layer (140) overlapping the channel region (CH). The second transistor (T2) includes a second gate structure (GS2) including a second gate electrode layer (240), a channel structure (220) contacting the bit line (BL), the channel structure (220) including a first horizontal portion (220a) extending in a first horizontal direction away from the bit line (BL), and a vertical portion (220b) extending vertically from one end of the first horizontal portion (220a), and a storage node (SN) between the first gate electrode layer (140) and the second gate electrode layer (240), and the storage node (SN) connected to the channel structure (220).

## Description

### BACKGROUND

Example embodiments of the inventive concepts relate to a semiconductor device and a method for manufacturing the same.

It may be advantageous for semiconductor devices mounted on electronic devices to be miniaturized, as well as to have higher performance and higher capacities. In order to achieve these characteristics, semiconductor devices in which each memory cell includes two transistors are being developed.

### SUMMARY

Some example embodiments of the present inventive concepts provide a semiconductor device having improved reliability.

According to some example embodiments of the present inventive concepts, a semiconductor device includes a bit line extending in a vertical direction, and a 2-transistor (2T) memory cell on at least one side of the bit line, the 2-transistor (2T) memory cell including a first transistor and a second transistor on the first transistor. The first transistor includes an active pattern contacting the bit line, the active pattern including a first source/drain region, a second source/drain region, and a channel region between the first source/drain region and the second source/drain region, and a first gate structure including a first gate electrode layer overlapping at least a portion of the channel region of the active pattern. The second transistor includes a second gate structure including a second gate electrode layer, a channel structure contacting the bit line, the channel structure including a first horizontal portion extending a first horizontal direction away from the bit line from a portion in contact with the bit line, and a vertical portion extending vertically from one end of the first horizontal portion, and a storage node between the first gate electrode layer and the second gate electrode layer, and the storage node connected to the channel structure.

According to some example embodiments of the present inventive concepts, a semiconductor device includes a plurality of two-transistor (2T) memory cells arranged vertically on a substrate. Each two-transistor (2T) memory cell of the plurality of two-transistor (2T) memory cells includes a first transistor, a second transistor, and an insulating material layer between the first and second transistors. The first transistor includes an active pattern extending in a first horizontal direction, the active pattern including a first source/drain region, a second source/drain region, and a channel region between the first source/drain region and the second source/drain region, and a first gate electrode overlapping at least a portion of the channel region of the active pattern. The second transistor includes a second gate electrode layer, a channel structure including a horizontal portion extending horizontally, and a vertical portion extending vertically from one end of the horizontal portion, on the second gate electrode layer, and a storage node having at least a portion vertically overlapping the channel region, and connected to the channel structure.

According to some example embodiments of the present inventive concepts, a semiconductor device includes a bit line extending in a vertical direction, a first transistor including a first active pattern including a first channel region extending in a first horizontal direction on at least one side of the bit line, and a first gate electrode overlapping at least a portion of the first channel region, and a second transistor including a second active pattern on the first transistor and including a second channel region having horizontal and vertical portions, a second gate electrode overlapping at least a portion of the second channel region, and a storage node contacting the second active pattern and having at least a portion vertically overlapping the first channel region.

### BRIEF DESCRIPTION OF DRAWINGS

The above example embodiments, and other aspects, features, and advantages of the present inventive concepts will be more clearly understood from the following detailed description, taken in conjunction with the accompanying drawings, in which:
FIG. 1 is a plan view illustrating a semiconductor device according to some example embodiments.
FIG. 2A is a partially enlarged view of the semiconductor device illustrated in FIG. 1. FIG. 2A is a circuit diagram of a memory cell in a memory cell region according to some example embodiments.
FIG. 2B is a timing diagram of a memory cell according to some example embodiments.
FIG. 3A is a vertical cross-sectional view of the memory cell region illustrated in FIG. 1, along line I-I'.
FIG. 3B is a vertical cross-sectional view of the memory cell region illustrated in FIG. 1, along line II-II'.
FIG. 3C is a perspective view illustrating a semiconductor device according to some example embodiments.
FIG. 4 is a partially enlarged view of a semiconductor element according to some example embodiments.
FIGS. 5 to 8 are partially enlarged views of semiconductor elements according to some example embodiments.
FIGS. 9, 11, 14, 16, 21, 23, 26, 32, and 34 are plan views illustrating in a process sequence for illustrating a method for manufacturing a semiconductor device according to some example embodiments.
FIGS. 10A, 10B, 12A, 12B, 13A, 13B, 15A, 15B, 17A, 17B, 18A, 18B, 19A, 19B, 20A, 20B, 22A, 22B, 24A, 24B, 25A, 25B, 27A, 27B, 28A, 28B, 29A, 29B, 30A, 30B, 31A, 31B, 33A, 33B, 35A, 35B, 36A, 36B, 37A, and 37B are vertical cross-sectional views illustrating in a process sequence for illustrating a method for manufacturing a semiconductor device according to some example embodiments.

### DETAILED DESCRIPTION

Hereinafter, terms such as 'on,' 'upper,' 'upper portion,' 'upper surface,' 'below,' 'lower,' 'lower portion,' 'lower surface,' 'side surface,' 'upper end,' 'lower end' and the like can be understood to refer to the drawings, except in cases in which they are indicated separately by drawing symbols. Terms such as "upper," "upper portion," "intermediate," "lower," "lower portion," and the like may be replaced with other terms, such as "first," "second," "third," and the like, and used to describe components of the specification. Terms such as "first," "second," "third," and the like may be used to describe various components, but components are not limited by the terms, and "first component" may be named "second component."

Hereinafter, some example embodiments of the present inventive concepts will be described as follows with reference to the attached drawings.

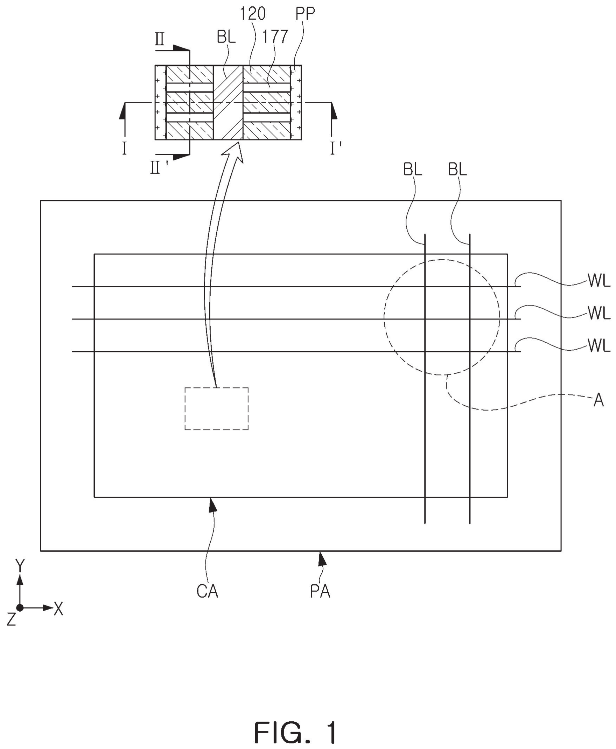

FIG. 1 is a plan view illustrating a semiconductor device according to some example embodiments.

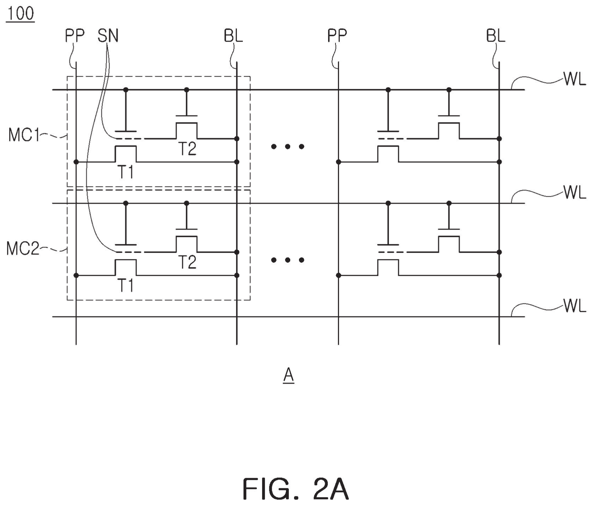

FIG. 2A is a partially enlarged view of the semiconductor device illustrated in FIG. 1. FIG. 2A is a partially enlarged view of portion 'A' of FIG. 1, and a circuit diagram of a memory cell in a memory cell area according to some example embodiments.

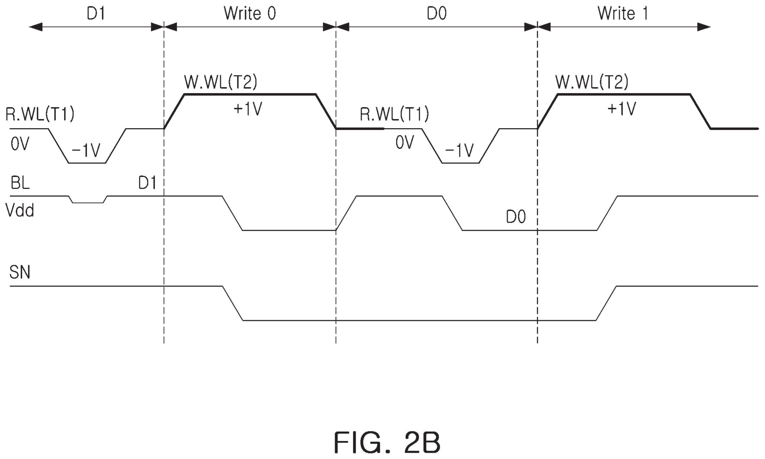

FIG. 2B is a timing diagram of a memory cell according to some example embodiments.

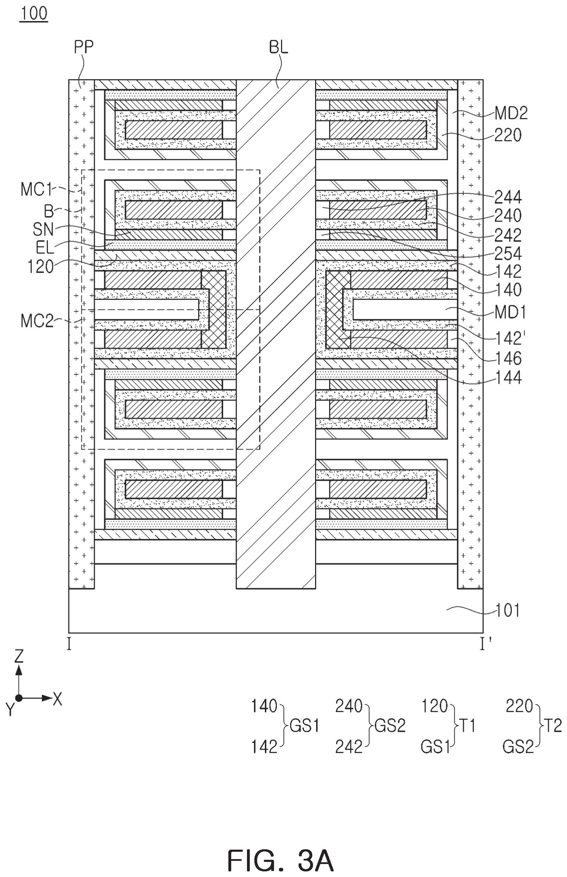

FIG. 3A is a vertical cross-sectional view of the memory cell area illustrated in FIG. 1, along line I-I'.

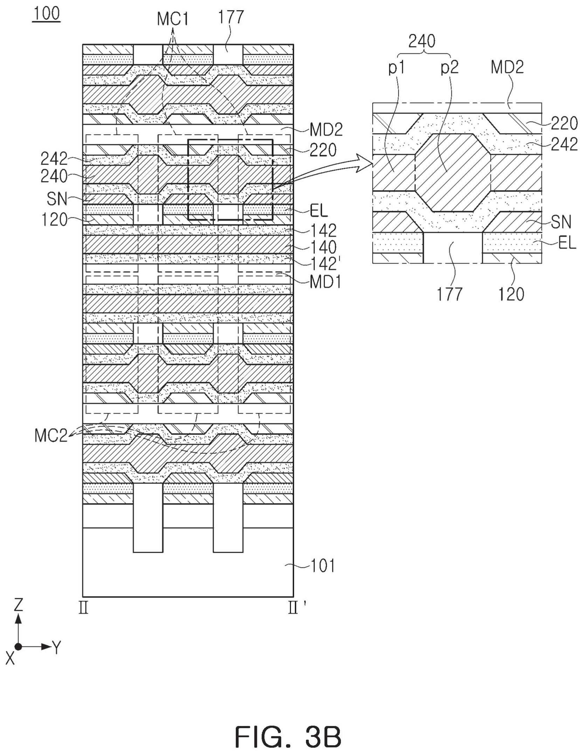

FIG. 3B is a vertical cross-sectional view of the memory cell area illustrated in FIG. 1, along line II-II'.

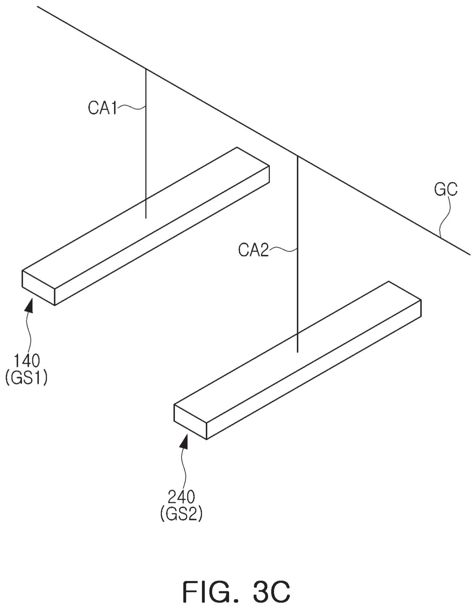

FIG. 3C is a perspective view illustrating a semiconductor device according to some example embodiments.

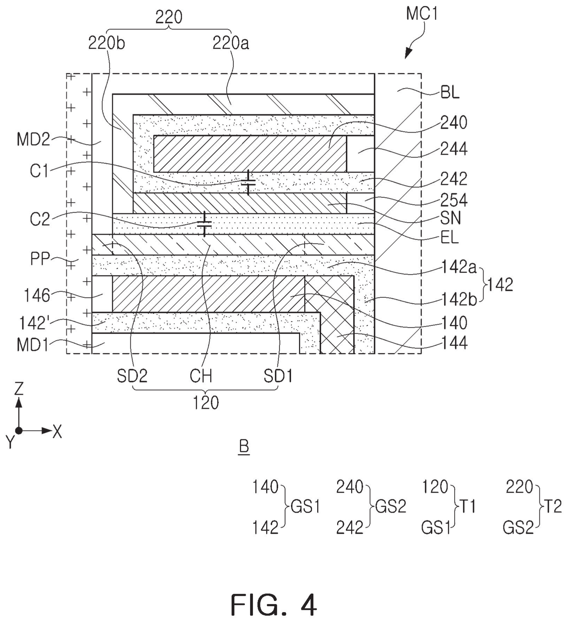

FIG. 4 is a partially enlarged view of a semiconductor element according to some example embodiments. FIG. 4 is a partially enlarged view of portion 'B' of FIG. 3A.

Referring to FIGS. 1 to 4, a semiconductor device 100 according to some example embodiments of the present inventive concepts may include a cell area CA and a peripheral circuit area PA. The peripheral circuit area PA may be disposed to surround the cell area CA. An interface area (not illustrated) may be disposed between the cell area CA and the peripheral circuit area PA. The cell area CA may refer to an area in which memory cells of a dynamic random access memory (DRAM) device are disposed, and the peripheral circuit area PA may be an area in which word line drivers, sense amplifiers, row and column decoders, and control circuits are disposed. The interface area (not illustrated) may be an area for electrically connecting the cell area CA to the peripheral circuit area PA.

A semiconductor device 100 according to some example embodiments of the present inventive concepts may include a substrate 101, a plurality of memory cells (e.g., MC1 and MC2), a bit line BL, and a plate electrode layer PP in the cell area CA. For example, the semiconductor device 100 may be applied to a cell array of a dynamic random access memory (DRAM), but example embodiments are not limited thereto.

The substrate 101 may include a semiconductor material, such as a group IV semiconductor, a group III-V compound semiconductor, or a group II-VI compound semiconductor. For example, the group IV semiconductor may include silicon, germanium, or silicon-germanium. The substrate 101 may be a silicon substrate, a silicon-on-insulator (SOI) substrate, a germanium substrate, a germanium-on-insulator (GOI) substrate, a silicon-germanium substrate, or a substrate including an epitaxial layer. However, example embodiments are not limited thereto.

A plurality of memory cells MC1 and MC2 may be arranged vertically on the substrate 101 on a plurality of levels. The plurality of memory cells MC1 and MC2 may be, for example, repeatedly stacked vertically on the substrate 101. The plurality of memory cells MC1 and MC2 may include first and second memory cells MC1 and MC2 arranged vertically. Each of the plurality of memory cells MC1 and MC2 may include first and second transistors T1 and T2. In some example embodiments, the first and second transistors T1 and T2 may be collectively referred to as a 2-transistor (2T), and thus, each of the plurality of memory cells MC1 and MC2 may be referred to as a 2-transistor (2T) memory cell. In some example embodiments, the first transistor T1 may be referred to as a read transistor, and the second transistor T2 may be referred to as a write transistor.

The first transistor T1 may include an active pattern 120 and a first gate structure GS1.

The active pattern 120 may be disposed on the substrate 101, and may extend horizontally in a first horizontal direction (e.g., X-direction). Active patterns 120 may be spaced apart from each other in a second horizontal direction (e.g., Y-direction) by a mold insulating structure 177. The active patterns 120 may be disposed to be spaced apart from each other in a vertical direction. In some example embodiments, the active pattern 120 may include a semiconductor material, for example, silicon, germanium, or silicon-germanium. However, example embodiments are not limited thereto.

The active pattern 120 may include first and second source/drain regions SD1 and SD2 and a channel area CH. Each of the first and second source/drain regions SD1 and SD2 may be referred to as first and second impurity regions. The first source/drain region SD1 and the second source/drain region SD2 may be disposed on both ends of the first horizontal direction (e.g., X-direction) of the active pattern 120, and the channel region CH may be disposed between the first source/drain region SD1 and the second source/drain region SD2.

The first source/drain region SD1 may be, for example, adjacent to the bit line BL and in contact with the bit line BL. The second source/drain region SD2 may be, for example, adjacent to the plate electrode layer PP and in contact with the plate electrode layer PP.

A boundary between the first source/drain region SD1 and the channel region CH may be aligned with a first side surface of a portion of a first gate electrode 140, adjacent to the bit line BL, but example embodiments are not limited thereto. For example, the boundary between the first source/drain region SD1 and the channel region CH may not be aligned with the first side surface of the first gate electrode 140.

A boundary between the second source/drain region SD2 and the channel region CH may be aligned with a second side surface of a portion of the first gate electrode 140, adjacent to the plate electrode layer PP, but example embodiments are not limited thereto. For example, the boundary between the second source/drain region SD2 and the channel region CH may not be aligned with the second side surface of the first gate electrode 140.

The active pattern 120 may include a semiconductor material such as silicon or the like. The active pattern 120 may include, for example, single crystal silicon or polysilicon.

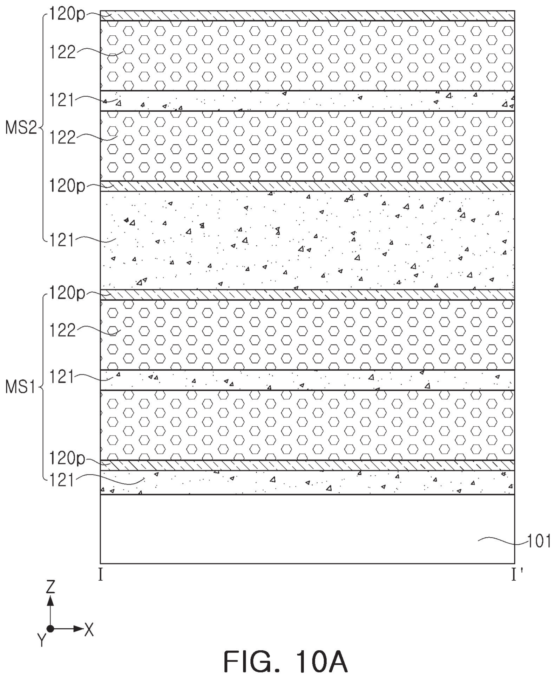

In some example embodiments, it can be understood that forming a first channel material layer (120p of FIG. 10A) of single crystal silicon such that the active pattern 120 of the semiconductor device 100 includes single crystal silicon, is as being due to an advantage that the first channel material layer 120p remains without being removed from the mold structures MS1 and MS2.

In some example embodiments, the active pattern 120 may include an oxide semiconductor layer. In this case, the active pattern 120 may not include separate first and second source drain regions SD1 and SD2.

The oxide semiconductor layer may include, for example, indium gallium zinc oxide (IGZO), but example embodiments are not limited thereto. For example, the oxide semiconductor layer may include at least one of indium tungsten oxide (IWO), indium tin gallium oxide (ITGO), indium aluminum zinc oxide (IAGO), indium gallium oxide (IGO), indium tin zinc oxide (ITZO), zinc tin oxide (ZTO), indium zinc oxide (IZO), ZnO, indium gallium silicon oxide (IGSO), indium oxide (InO), tin oxide (SnO), titanium oxide (TiO), zinc oxynitride (ZnON), magnesium zinc oxide (MgZnO), indium zinc oxide (InZnO), indium gallium zinc oxide (InGaZnO), zirconium indium zinc oxide (ZrInZnO), hafnium indium zinc oxide (HfInZnO), tin indium zinc oxide (SnInZnO), aluminum tin indium zinc oxide (AlSnInZnO), silicon indium zinc oxide (SilnZnO), zinc tin oxide (ZnSnO), aluminum zinc tin oxide (AlZnSnO), gallium zinc tin oxide (GaZnSnO), zirconium zinc tin oxide (ZrZnSnO), or indium gallium silicon oxide (InGaSiO). However, example embodiments are not limited thereto.

The first gate structure GS1 may include a first gate electrode 140 and a first gate dielectric layer 142.

The first gate electrode 140 may extend in the first horizontal direction (e.g., X-direction), and may vertically overlap the channel region CH of the active pattern 120. The first gate electrode 140 may extend in the second horizontal direction (e.g., Y-direction). In some example embodiments, the first gate electrode 140 may be referred to as a first gate electrode layer.

The first gate dielectric layer 142 may include a first portion 142a extending in the first horizontal direction (e.g., X-direction) between the active pattern 120 and the first gate electrode 140, and a second portion 142b connected to an end portion of the first portion 142a and extending vertically between the first gate electrode 140 and the bit line BL.

The first gate dielectric layer 142 may include at least one of silicon oxide, silicon nitride, a low-κ material, or a high-κ material. However, example embodiments are not limited thereto. The high-κ material may mean a dielectric material having a higher dielectric constant than silicon oxide, and the low-κ material may mean a dielectric material having a lower dielectric constant than silicon oxide. The high-κ material may be, for example, a metal oxide or a metal oxynitride. The high-κ material may be, for example, any one of aluminum oxide (Al₂O₃), tantalum oxide (Ta₂O₃), titanium oxide (TiO₂), yttrium oxide (Y₃O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), or praseodymium oxide (Pr₂O₃). However, example embodiments are not limited thereto. The first gate dielectric layer 142 may be formed as a single layer or plurality of layers of the above-mentioned materials.

In some example embodiments, the first gate structure GS1 may further include an insulating liner 142' covering the first gate electrode 140 between a first mold insulating layer MD1 and the first gate electrode 140. The insulating liner 142' may be located on an opposite side of the first gate dielectric layer 142 with respect to the first gate electrode 140. The insulating liner 142' may include a first portion extending in the first horizontal direction (e.g., X-direction) between the first mold insulating layer MD1 and the first gate electrode 140, and a second portion connected to an end of the first portion and extending vertically between the first mold insulating layer MD1 and the first gate capping layer 144.

In some example embodiments, the semiconductor device 100 may further include a plurality of gate capping layers 144 and 146. The plurality of gate capping layers 144 and 146 may include a first gate capping layer 144 between the first gate electrode 140 and the bit line BL, and a second gate capping layer 146 between the first gate electrode 140 and the plate electrode layer PP. In some example embodiments, the first and second gate capping layers 144 and 146 may be collectively referred to as the first gate capping layer.

The first and second gate capping layers 144 and 146 may include at least one of an insulating material, for example, silicon oxide, silicon nitride, silicon oxynitride, or silicon oxycarbide. However, example embodiments are not limited thereto. For example, the first gate capping layer 144 may include silicon nitride, and the second gate capping layer 146 may include silicon oxide.

The second transistor T2 may include a second gate structure GS2, a channel structure 220, and a storage node SN.

The second gate structure GS2 may include a second gate electrode 240 and a second gate dielectric layer 242.

The second gate electrode 240 may include a portion extending in the first horizontal direction (e.g., X-direction). The second gate electrode 240 may extend in the second horizontal direction (e.g., Y-direction). In some example embodiments, the second gate electrode 240 may be referred to as a second gate electrode layer.

In a vertical direction (e.g., Z-direction), the second gate electrode 240 may include a first portion p1 overlapping the storage node SN, and a second portion p2 overlapping the mold insulating structure 177 (see FIG. 3B). First portions p1 may be spaced apart in the second horizontal direction (e.g., Y-direction), and second portions p2 may be spaced apart in the second horizontal direction. The first and second portions p1 and p2 may be disposed alternately in the second horizontal direction, for example.

The second gate electrode 240 may have a different shape from the first gate electrode 140. For example, a maximum thickness of the first portion p1 in the vertical direction may be less than a maximum thickness of the second portion p2 in the vertical direction. The first gate electrode layer 140 may extend on a same or constant level in the second horizontal direction (e.g., Y-direction).

The second gate dielectric layer 242 may surround upper, lower, and side portions of the second gate electrode 240 between the channel structure 220 and the second gate electrode 240.

The second gate dielectric layer 242 may include at least one of silicon oxide, silicon nitride, a low-κ material, or a high-κ material. However, example embodiments are not limited thereto. The high-κ material may mean a dielectric material having a higher dielectric constant than silicon oxide, and the low-κ material may mean a dielectric material having a lower dielectric constant than silicon oxide. The high-κ dielectric material may be, for example, a metal oxide or a metal oxynitride. The high-κ dielectric material may be, for example, any one of aluminum oxide (Al₂O₃), tantalum oxide (Ta₂O₃), titanium oxide (TiO₂), yttrium oxide (Y₃O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), or praseodymium oxide (Pr₂O₃). However, example embodiments are not limited thereto. The second gate dielectric layer 242 may be formed as a single layer or plurality of layers of the above-described materials.

In some example embodiments, the semiconductor device 100 may further include a second gate capping layer 244. The second gate capping layer 244 may be disposed between the second gate electrode 240 and the bit line BL. The second gate capping layer 244 may include at least one of an insulating material, for example, silicon oxide, silicon nitride, silicon oxynitride, or silicon oxycarbide. However, example embodiments are not limited thereto.

The channel structure 220 may include a horizontal portion 220a extending in the first horizontal direction (e.g., X-direction) away from the bit line BL from a portion contacting the bit line BL, and a vertical portion 220b connected to an end portion of the horizontal portion 220a and extending vertically between the second gate electrode 240 and the plate electrode layer PP.

In the second transistors T2 adjacent in the vertical direction (e.g., Z-direction), channel structures 220 may be spaced apart in the vertical direction, with a second mold insulating layer MD2 therebetween. For example, the horizontal portion 220a of the channel structure 220 in an upper portion and the horizontal portion 220a of the channel structure 220 in a lower portion may face each other, with the second mold insulating layer MD2 therebetween. In addition, the vertical portion 220b of the channel structure 220 in the upper portion and the vertical portion 220b of the channel structure 220 in the lower portion may extend away from each other, with the second mold insulating layer MD2 therebetween. In another aspect, in second transistors T2 adjacent in the vertical direction (e.g., Z-direction), channel structures 220 may be symmetrical with respect to the second mold insulating layer MD2.

In some example embodiments, the channel structure 220 may include an oxide semiconductor layer.

The oxide semiconductor layer may include indium gallium zinc oxide (IGZO). For example, the oxide semiconductor layer may include at least one of indium tungsten oxide (IWO), indium tin gallium oxide (ITGO), indium aluminum zinc oxide (IAGO), indium gallium oxide (IGO), indium tin zinc oxide (ITZO), zinc tin oxide (ZTO), indium zinc oxide (IZO), ZnO, indium gallium silicon oxide (lGSO), indium oxide (InO), tin oxide (SnO), titanium oxide (TiO), zinc oxynitride (ZnON), magnesium zinc oxide (MgZnO), indium zinc oxide (InZnO), indium gallium zinc oxide (InGaZnO), zirconium indium zinc oxide (ZrInZnO), hafnium indium zinc oxide (HfInZnO), tin indium zinc oxide (SnInZnO), aluminum tin indium zinc oxide (AlSnInZnO), silicon indium zinc oxide (SilnZnO), zinc tin oxide (ZnSnO), aluminum zinc tin oxide (AlZnSnO), gallium zinc tin oxide (GaZnSnO), zirconium zinc tin oxide (ZrZnSnO), or indium gallium silicon oxide (InGaSiO). However, example embodiments are not limited thereto.

The storage node SN may be disposed between the first and second gate electrodes 140 and 240, and may be connected to the channel structure 220. An end portion of the storage node SN may be, for example, in contact with a side surface of the vertical portion 220b.

The storage node SN may include a portion overlapping at least a portion of each of the first gate electrode 140 and the active pattern 120 of the first transistor T1. The storage node SN may include a portion overlapping at least a portion of the first gate electrode 140 in the vertical direction (e.g., Z-direction), for example. The storage node SN may include, for example, a portion overlapping at least a portion of the channel region CH of the active pattern 120 in the vertical direction (e.g., Z-direction).

The storage node SN may include metal or a metal nitride. For example, the storage node SN may include titanium nitride, tungsten, ruthenium, molybdenum, or the like. However, example embodiments are not limited thereto.

An insulating capping layer 254 may be disposed between the storage node SN and the bit line BL. The insulating capping layer 254 may be configured to separate the storage node SN from the bit line BL. The insulating capping layer 254 may include an insulating material, for example, at least one of silicon oxide, silicon nitride, silicon oxynitride, or silicon oxycarbide. However, example embodiments are not limited thereto.

According to some example embodiments of the present inventive concepts, the semiconductor device 100 may include a transistor that may operate in a complementary MOSFET (CMOS) circuit. For example, the first and second transistors T1 and T2 of the semiconductor device 100 may be transistors having different doping characteristics.

According to some example embodiments of the present inventive concepts, the first transistor T1 may be a PMOS transistor, and the second transistor T2 may be an NMOS transistor. In this case, the channel region CH may be formed as a P-type, and the channel structure 220 may be formed as an N-type. In this case, the channel region CH may be referred to as a P-type channel, and the channel structure 220 may be referred to as an N-type channel.

However, some example embodiments is not limited thereto. For example, the first transistor T1 may be an NMOS transistor, and the second transistor T2 may be a PMOS transistor. In this case, the channel region CH may be formed as an N-type, and the channel structure 220 may be formed as a P-type. In this case, the channel region CH may be referred to as an N-type channel, and the channel structure 220 may be referred to as a P-type channel.

The semiconductor device 100 may further include an insulating material layer EL between the first and second transistors T1 and T2. The insulating material layer EL may be configured to allow each of the first and second transistors T1 and T2 to perform operations independently.

The insulating material layer EL may extend in the first horizontal direction (e.g., X-direction), and one end of the insulating material layer EL may be in contact with the bit line BL. The insulating material layer EL may be spaced apart from each other in the second horizontal direction (e.g., Y-direction) by the mold insulating structure 177. Insulating material layers EL may be disposed to be spaced apart from each other in the vertical direction.

The insulating material layer EL may be in contact with a channel portion of each of the transistors T1 and T2. For example, the insulating material layer EL may be in contact with the active pattern 120 of the first transistor T1. The insulating material layer EL may be in contact with the channel structure 220 of the second transistor T2 and the storage node SN. The storage node SN may face the active pattern 120 with the insulating material layer EL therebetween. The storage node SN may include, for example, a portion overlapping the channel region CH of the active pattern 120 in the vertical direction (e.g., Z-direction) with the insulating material layer EL therebetween.

The insulating material layer EL may include a high-κ material. The high-κ material may be, for example, any one of aluminum oxide (Al₂O₃), tantalum oxide (Ta₂O₃), titanium oxide (TiO₂), yttrium oxide (Y₃O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), or praseodymium oxide (Pr₂O₃). However, example embodiments are not limited thereto.

The semiconductor device 100 may further include mold insulating layers MD1 and MD2 covering each of the transistors T1 and T2. The first mold insulating layer MD1 may cover the first transistor T1, and the second mold insulating layer MD2 may cover the second transistor T2. The first mold insulating layer MD1 may cover the first transistor T1 vertically adjacent to each other in one side of the plate electrode layer PP. The second mold insulating layer MD2 may cover the second transistor T2 vertically adjacent to each other between the plate electrode layer PP and the bit line BL. The second mold insulating layer MD2 may be in contact with a source/drain region (e.g., SD2) of the active pattern 120 of the first transistor T1, and may be in contact with the channel structure 220 of the second transistor T2. The second mold insulating layer MD2 may be in contact with the insulating material layer EL.

First transistors T1 may be vertically adjacent to each other, and second transistors T2 may be vertically adjacent to each other. For example, a first transistor T1 of a first memory cell MC1 and a first transistor T1 of a second memory cell MC2 may be adjacent in the vertical direction. A second transistor T2 of the first memory cell MC1 and a second transistor T2 of a memory cell located above the first memory cell MC1 may be adjacent in the vertical direction.

Referring to FIG. 3B, the first memory cells MC1 adjacent in the second horizontal direction (e.g., Y-direction) may share the same gate electrode. For example, the first memory cells MC1 may share the first and second gate electrodes 140 and 240. From another perspective, the first memory cells MC1 may share the same word line. From the same aspect, the second memory cells MC2 adjacent in the second horizontal direction (e.g., Y-direction) may share the same word line.

The first and second gate electrodes 140 and 240 may be electrically connected to each other (see FIG. 3C). For example, the first and second gate electrodes 140 and 240 may share a gate interconnection GC. The first gate electrode 140 may be connected, for example, by the gate interconnection GC and a first contact structure CA1, and the second gate electrode 240 may be connected, for example, by the gate interconnection GC and a second contact structure CA2. In this case, the gate interconnection GC may correspond to the word line WL of FIG. 1 and FIG. 2A.

The bit line BL may extend in the second horizontal direction (e.g., Y-direction) and the vertical direction on the substrate 101. The bit lines BL may be disposed to be spaced apart from each other in the first horizontal direction (e.g., X-direction) and the second horizontal direction (e.g., Y-direction). The active patterns 120 may be electrically connected to one bit line BL. For example, the bit line BL may be electrically connected to the first source/drain regions SD1 of the active patterns 120. The channel structure 220 may be electrically connected to one bit line BL. For example, the bit line BL may be electrically connected to the horizontal portion 220a of the channel structure 220.

The semiconductor device 100 may be symmetrical with respect to the bit line BL. For example, first memory cells MC1 may be arranged symmetrically with respect to the bit line BL, and second memory cells MC2 may be arranged symmetrically with respect to the bit line BL.

The bit line BL may include at least one of a doped semiconductor material, a conductive metal nitride, metal, and a metal-semiconductor compound. For example, the bit line BL may include doped polysilicon.

The plate electrode layer PP may extend in the second horizontal direction (e.g., Y-direction) and in the vertical direction on the substrate 101. The plate electrode layer PP may be disposed to be spaced apart from each other in the first horizontal direction (e.g., X-direction) and the second horizontal direction (e.g., Y-direction). The plate electrode layer PP may face the bit line BL, for example, in the first horizontal direction (e.g., X-direction).

The plate electrode layer PP may include at least one of a doped semiconductor material, a conductive metal nitride, metal, and a metal-semiconductor compound. In some example embodiments, the plate electrode layer PP may include silicon-germanium. However, example embodiments are not limited thereto.

In an operation by the second transistor T2, a voltage may be applied to the second gate electrode 240, and current may flow through the channel structure 220 and the storage node SN. In this case, the operation by the second transistor T2 may be, for example, a write operation ('Write 0' section and 'Write 1' section of FIG. 2B), and current by the write operation may be referred to as a write current. As seen in FIG. 2B, when voltage is applied to the gate electrode 240, which is connected to the wordline, and when the reference potential Vdd of the bit line BL is decreased, charges are decreased in the storage node ('Write 0'). Alternatively, when voltage is applied to the gate electrode 240, which is connected to the wordline, and when the reference potential Vdd of the bit line BL is increased, charges are increased in the storage node ('Write 1').

The second gate electrode 240, the second gate dielectric layer 242, and the storage node SN may be viewed as a first capacitor C1, and the channel region CH, the insulating material layer EL, and the storage node SN may be viewed as a second capacitor C2. In this state, by operations of the first and second transistors T1 and T2, charges may be accumulated in the storage node SN, and data may be stored in the memory cell MC.

Amounts of charges accumulated in the storage node SN may affect a magnitude of a threshold voltage Vt of the first transistor T1. For example, amounts of charges accumulated in the storage node SN may cause a change in threshold voltage Vt of the first transistor T1 by ΔV. Potential of the bit line BL may change by ΔV, as compared to reference potential Vdd of the bit line BL. Depending on whether ΔV is greater than or less than an offset voltage of a bit line sense amplifier, data 0 (or 'binary 0') (D0 of FIG. 2B) or data 1 (or 'binary 1') (D1 of FIG. 2B) may be distinguished.

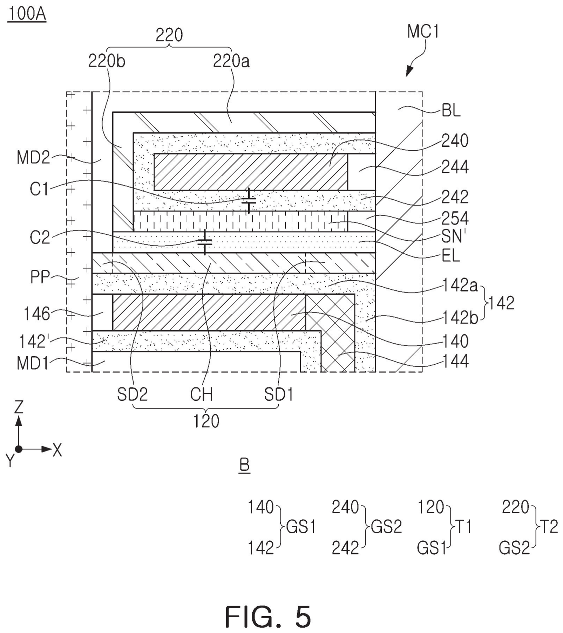

FIGS. 5 to 8 are partially enlarged views of semiconductor elements according to some example embodiments.

Referring to FIG. 5, a semiconductor device 100A may be identical or similar to that described with reference to FIGS. 1 to 4, except that a storage node SN' including a material, substantially identical to a material of a channel structure 220, is included.

The storage node SN' may include an oxide semiconductor layer.

The oxide semiconductor layer may include, for example, indium gallium zinc oxide (IGZO). For example, the oxide semiconductor layer may include at least one of indium tungsten oxide (IWO), indium tin gallium oxide (ITGO), indium aluminum zinc oxide (IAGO), indium gallium oxide (IGO), indium tin zinc oxide (ITZO), zinc tin oxide (ZTO), indium zinc oxide (IZO), ZnO, indium gallium silicon oxide (IGSO), indium oxide (InO), tin oxide (SnO), titanium oxide (TiO), zinc oxynitride (ZnON), magnesium zinc oxide (MgZnO), indium zinc oxide (InZnO), indium gallium zinc oxide (InGaZnO), zirconium indium zinc oxide (ZrInZnO), hafnium indium zinc oxide (HfInZnO), tin indium zinc oxide (SnInZnO), aluminum tin indium zinc oxide (AlSnInZnO), silicon indium zinc oxide (SilnZnO), zinc tin oxide (ZnSnO), aluminum zinc tin oxide (AlZnSnO), gallium zinc tin oxide (GaZnSnO), zirconium zinc tin oxide (ZrZnSnO), or indium gallium silicon oxide (InGaSiO). However, example embodiments are not limited thereto.

In some example embodiments, a concentration of an oxide semiconductor included in the storage node SN' may be different from a concentration of an oxide semiconductor included in the channel structure 220. In this case, the concentration of the oxide semiconductor may be a carrier concentration of the oxide semiconductor, and the carrier concentration may be appropriately controlled by doping.

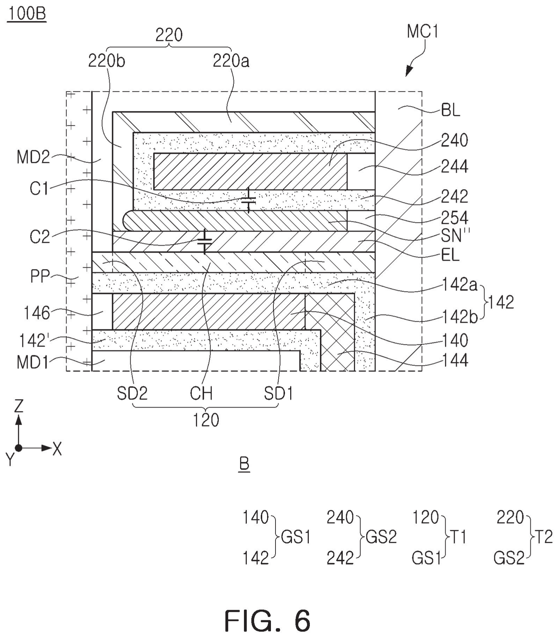

Referring to FIG. 6, a semiconductor device 100B may be identical or similar to that described with reference to FIGS. 1 to 5, except that a storage node SN" having a convex shape in a direction toward a channel structure 220 is included.

The storage node SN" may have a convex shape in a direction toward the channel structure 220. For example, an end of a storage node SN" may have a convex shape toward a vertical portion 220b of the channel structure 220. Therefore, at least a portion of a side surface of the vertical portion 220b may have a concave shape toward a plate electrode layer PP.

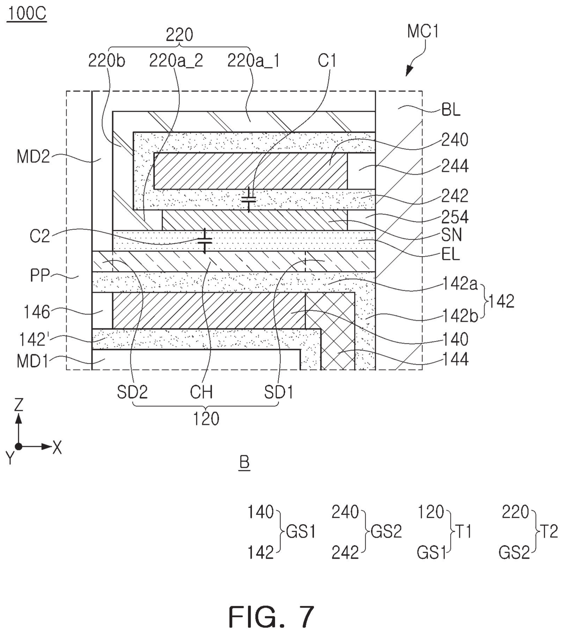

Referring to FIG. 7, a semiconductor device 100C may be identical or similar to that described with reference to FIGS. 1 to 6, except that a channel structure 220 having a plurality of horizontal portions 220a_1 and 220a_2 is included.

The channel structure 220 may include a first horizontal portion 220a_1 extending in a horizontal direction away from the bit line BL from a portion contacting a bit line BL, a vertical portion 220b connected to an end portion of the first horizontal portion 220a_1 and extending vertically between a second gate electrode 240 and a plate electrode layer PP, and a second horizontal portion 220a_2 connected to an end portion of the vertical portion 220b and extending in the horizontal direction closer to the bit line BL.

A length of the second horizontal portion 220a_2 in the horizontal direction may be less than a length of the first horizontal portion 220a_1 in the horizontal direction. A storage node SN may be connected to the second horizontal portion 220a_2. For example, the storage node SN may be in contact with an end portion of the second horizontal portion 220a_2. The second horizontal portion 220a_2 may not be in contact with the bit line BL, as compared to the first horizontal portion 220a_1.

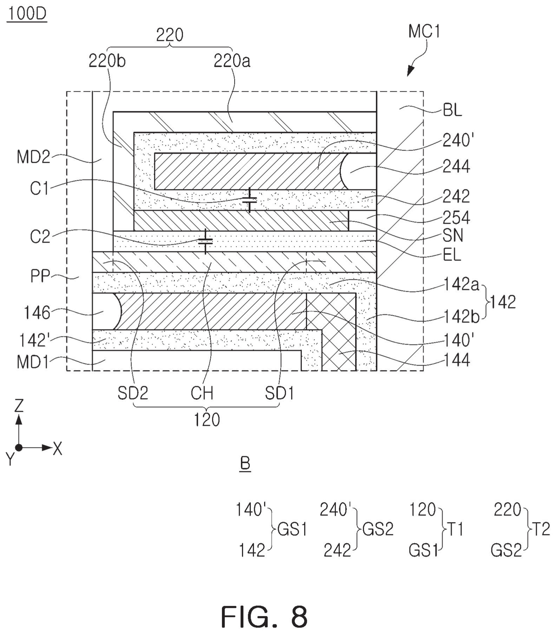

Referring to FIG. 8, a semiconductor device 100D may be identical or similar to that described with reference to FIGS. 1 to 7, except that gate electrode layers 140' and 240' having a side surface of a concave profile is included.

An end portion of a first gate electrode layer 140' may have a concave profile. For example, a side surface of a portion of the first gate electrode layers 140', adjacent to a plate electrode layer PP, may have a concave shape toward a bit line BL.

An end portion of a second gate electrode layer 240' may have a concave profile. For example, a side surface of a portion of the second gate electrode layers 240', adjacent to the bit line BL, may have a concave shape toward the plate electrode layer PP.

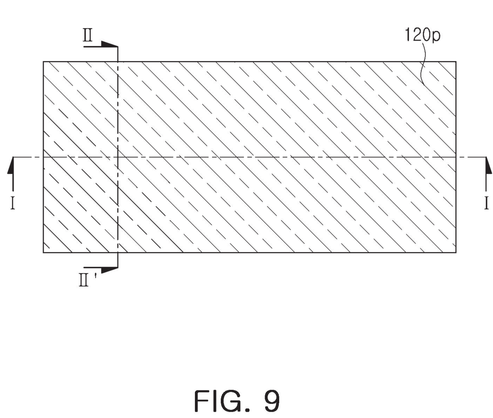

FIGS. 9, 11, 14, 16, 21, 23, 26, 32, and 34 are plan views illustrating in a process sequence for illustrating a method for manufacturing a semiconductor device according to some example embodiments.

FIGS. 10A, 10B, 12A, 12B, 13A, 13B, 15A, 15B, 17A, 17B, 18A, 18B, 19A, 19B, 20A, 20B, 22A, 22B, 24A, 24B, 25A, 25B, 27A, 27B, 28A, 28B, 29A, 29B, 30A, 30B, 31A, 31B, 33A, 33B, 35A, 35B, 36A, 36B, 37A, and 37B are vertical cross-sectional views illustrating in a process sequence for illustrating a method for manufacturing a semiconductor device according to some example embodiments.

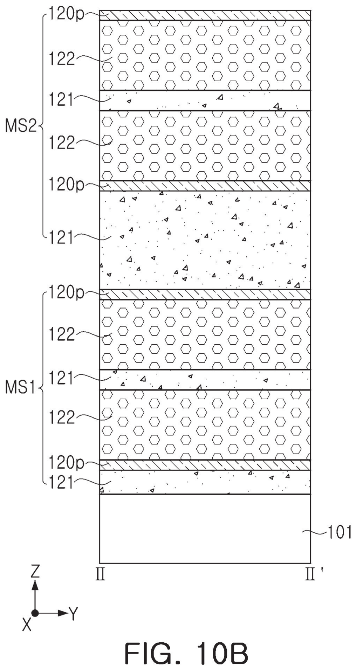

FIGS. 10A and 10B are vertical cross-sectional views along lines I-I' and II-II' of the memory cell area illustrated in FIG. 9.

Referring to FIGS. 9, 10A, and 10B, a first mold structure MS1 and a second mold structure MS2 may be formed on a substrate 101. The first and second mold structures MS1 and MS2 may be collectively referred to as a mold structure for convenience.

Each of the first and second mold structures MS1 and MS2 may include a first channel material layer 120p and a plurality of sacrificial layers 121 and 122, alternately stacked. For example, each of the first and second mold structures MS1 and MS2 may be a structure in which a first sacrificial layer 121, a first channel material layer 120p, a second sacrificial layer 122, a first sacrificial layer 121, a second sacrificial layer 122, and a first channel material layer 120p are sequentially stacked. A thickness of the first sacrificial layer 121 of the first mold structure MS1 may be less than a thickness of the second sacrificial layer 122 of the second mold structure MS2. Arrangement, combination, and a thickness of each of the first channel material layer 120p and the plurality of sacrificial layers 121 and 122 are not limited to those described above, and may be variously modified.

At least one separate second mold structure MS2 may be vertically stacked on the second mold structure MS2 (not illustrated).

Each of the first channel material layer 120p and the plurality of sacrificial layers 121 and 122 may have a different etch selectivity. For example, the first channel material layer 120p may include silicon (Si), the first sacrificial layer 121 may include silicon-germanium-carbon (SiGeC), and the second sacrificial layer 122 may include silicon-germanium (SiGe). However, example embodiments are not limited thereto.

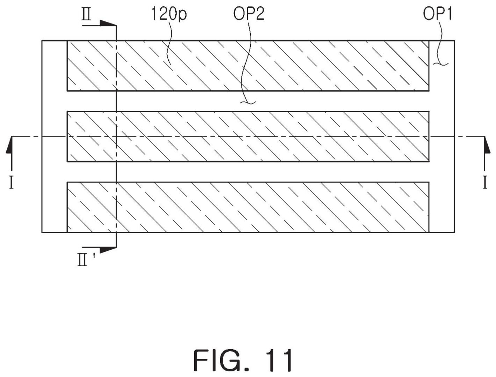

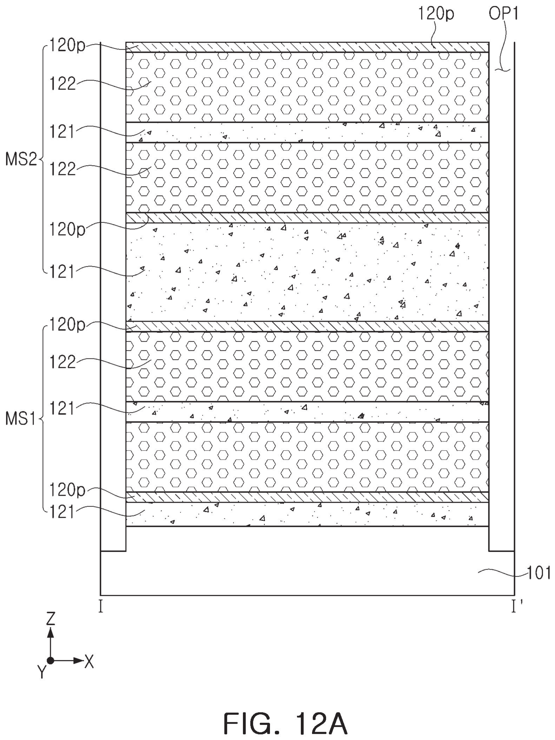

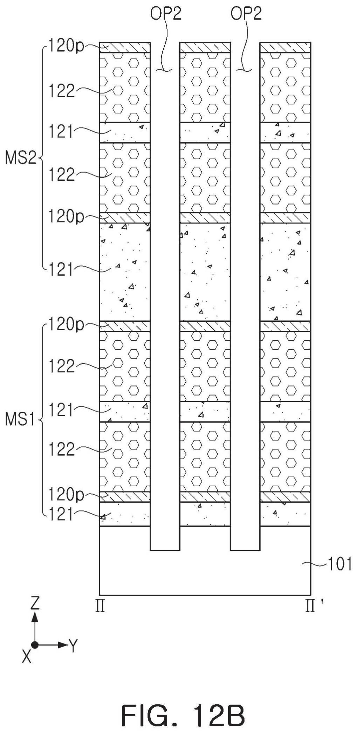

FIGS. 12A and 12B are vertical cross-sectional views taken along lines I-I' and II-II' of the memory cell area illustrated in FIG. 11.

Referring to FIGS. 11, 12A, and 12B, a plurality of open portions OP1 and OP2 penetrating the mold structure and exposing the substrate 101 may be formed.

The plurality of open portions OP1 and OP2 may include first open portions OP1 extending in the second horizontal direction (e.g., Y-direction), and second open portions OP2 extending in the first horizontal direction (e.g., X-direction). The first open portions OP1 may be formed to be spaced apart in the first horizontal direction (e.g., X-direction), and the second open portions OP2 may be formed to be spaced apart in the second horizontal direction (e.g., Y-direction).

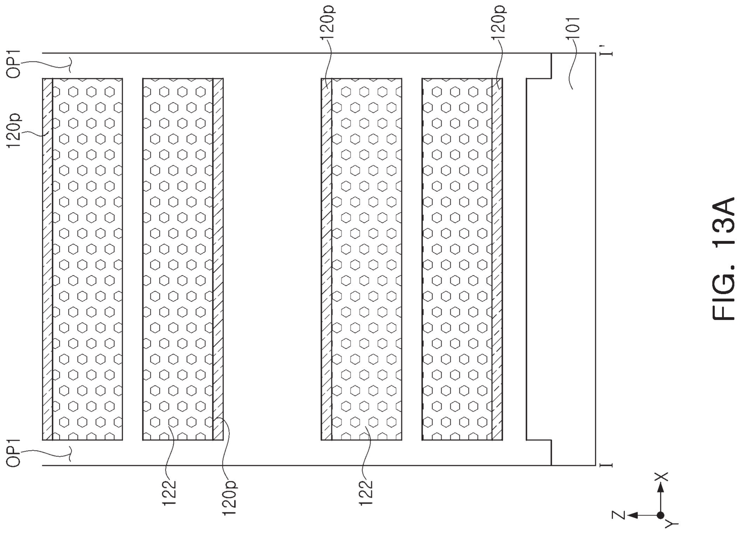

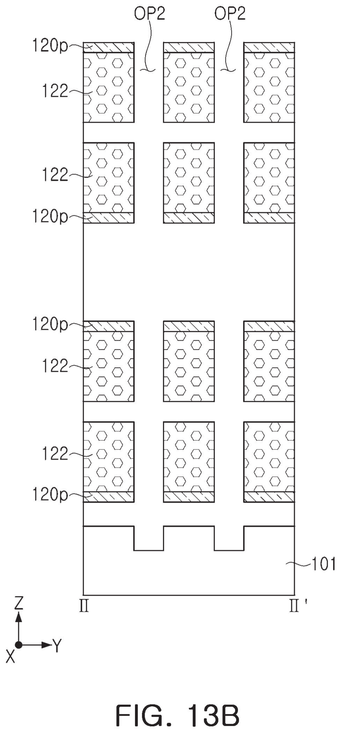

Referring to FIGS. 13A and 13B, the first sacrificial layer 121 may be removed.

The first sacrificial layer 121 exposed by the plurality of open portions OP1 and OP2 may be selectively removed. The first sacrificial layer 121 may be removed by an etching process in a lateral direction (e.g., X and/or Y-direction).

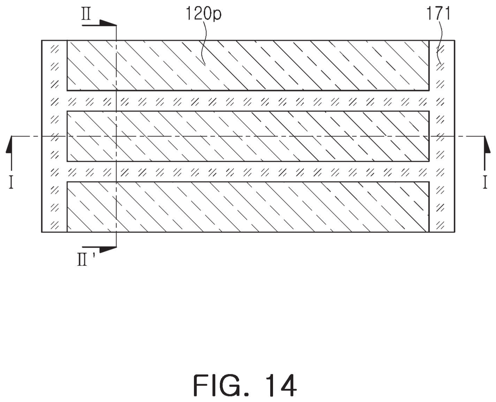

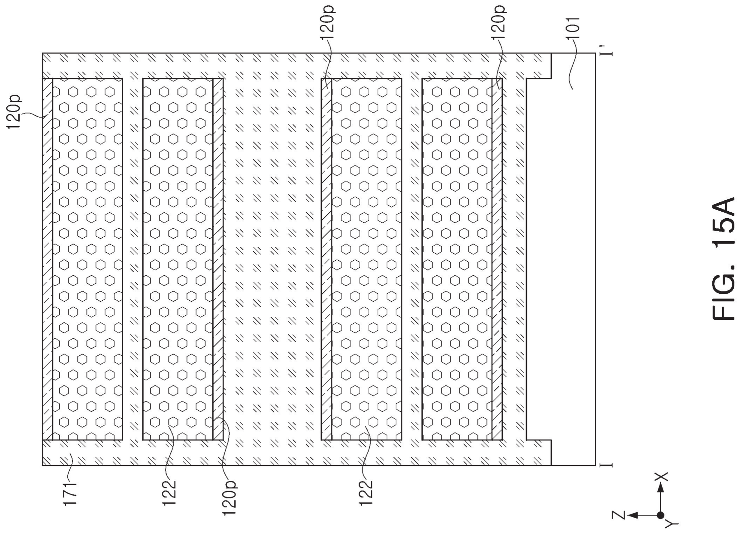

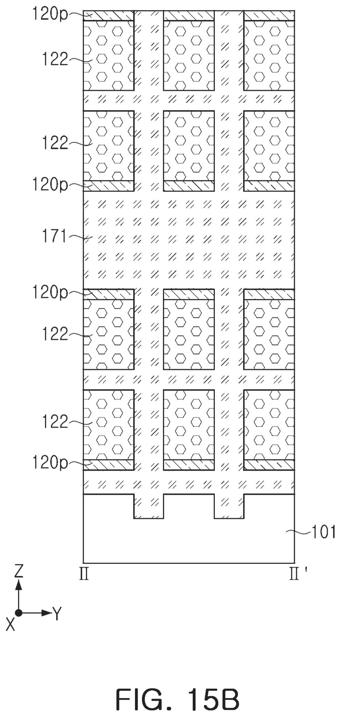

FIGS. 15A and 15B are vertical cross-sectional views along lines I-I' and II-II' of the memory cell area illustrated in FIG. 14.

Referring to FIGS. 14, 15A, and 15B, the plurality of open portions OP1 and OP2 may be filled with an insulating material to form a mold insulating layer 171.

The plurality of open portions OP1 and OP2 may be filled with an insulating material. The insulating material may completely fill between the second sacrificial layers 122 adjacent in the vertical direction. The insulating material may include at least one of, for example, silicon oxide, silicon nitride, silicon oxynitride, or silicon oxycarbide. The mold insulating layer 171 may include, for example, silicon nitride. However, example embodiments are not limited thereto.

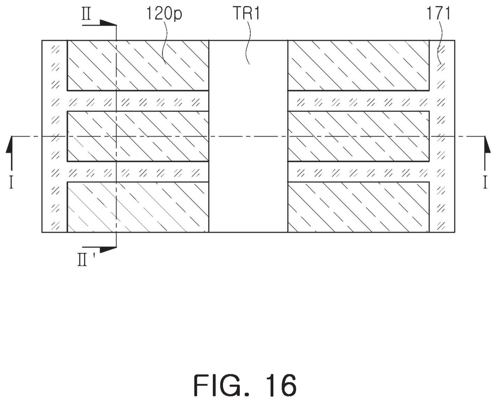

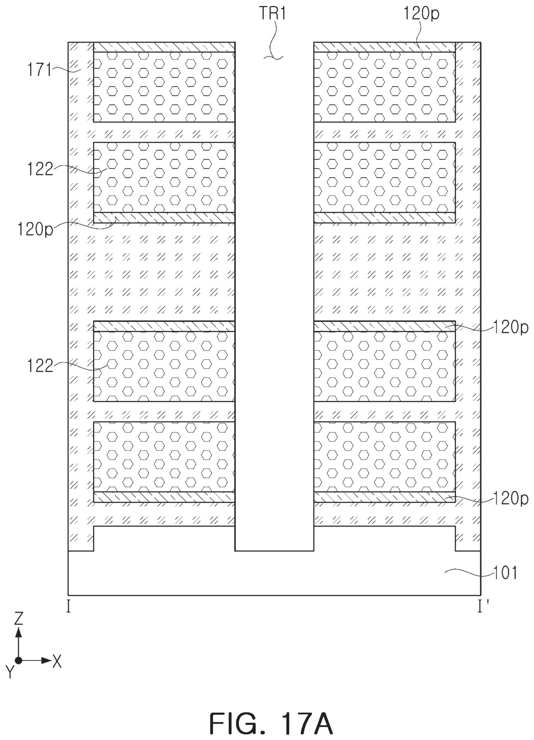

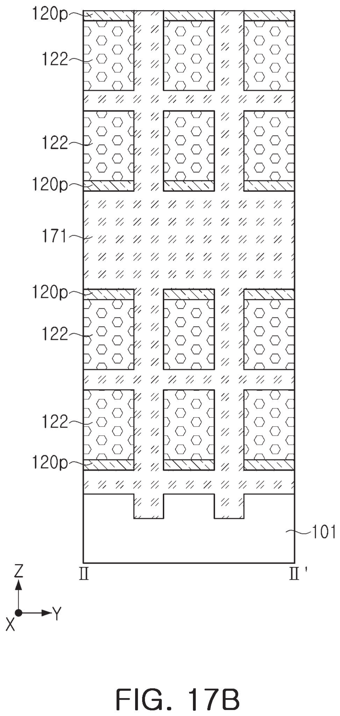

FIGS. 17A and 17B are vertical cross-sectional views along lines I-I' and II-II' of the memory cell area illustrated in FIG. 16.

Referring to FIGS. 16, 17A, and 17B, a first trench TR1 penetrating the first channel material layer 120p and the second sacrificial layer 122 and exposing the substrate 101 may be formed.

The first trench TR1 may extend in the second horizontal direction (e.g., Y-direction). The first trenches TR1 may be spaced apart in the first horizontal direction (e.g., X-direction).

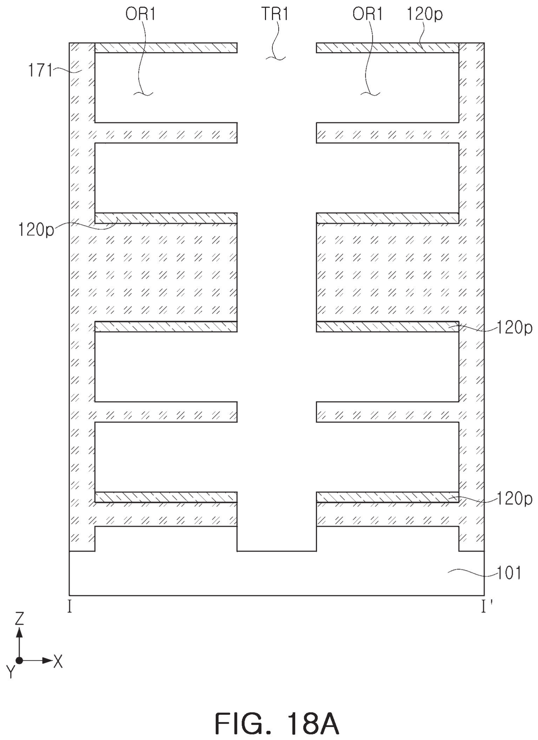

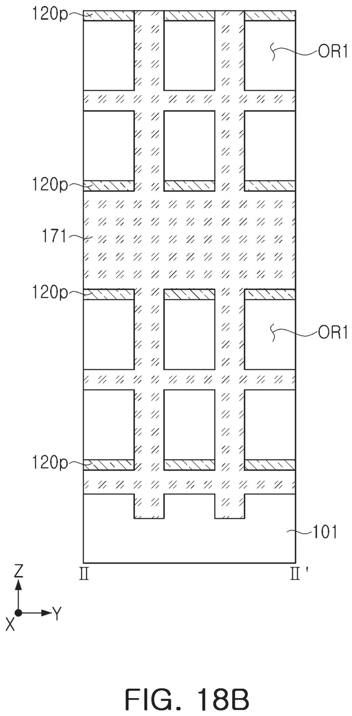

Referring to FIGS. 18A and 18B, the second sacrificial layer 122 may be removed.

The second sacrificial layer 122 exposed by the first trench TR1 may be selectively removed. The second sacrificial layer 122 may be removed by an etching process in the lateral direction (e.g., X and/or Y-direction). Therefore, a first open region OR1 extending horizontally from the first trench TR1 may be defined.

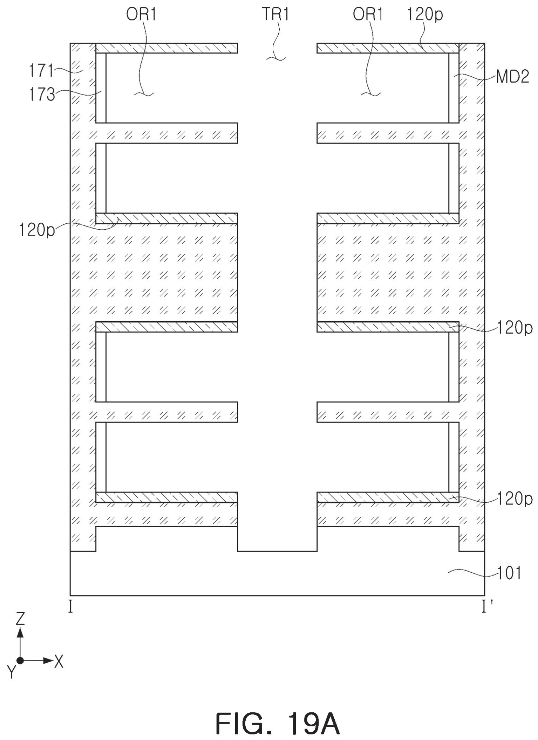

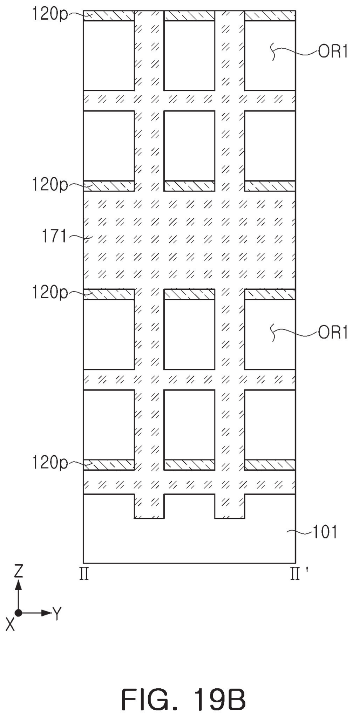

Referring to FIGS. 19A and 19B, an insulating liner 173 may be formed.

An insulating material may be deposited on a surface of the mold insulating layer 171 exposed by the first open region OR1, and a portion of the insulating material may be recessed to form the insulating liner 173. The portion of the insulating material to be recessed may include a portion extending horizontally on the mold insulating layer 171. Therefore, the insulating liner 173 may extend vertically.

The insulating material may include, for example, at least one of silicon oxide, silicon nitride, silicon oxynitride, or silicon oxycarbide. The insulating liner 173 may include, for example, silicon oxide. However, example embodiments are not limited thereto.

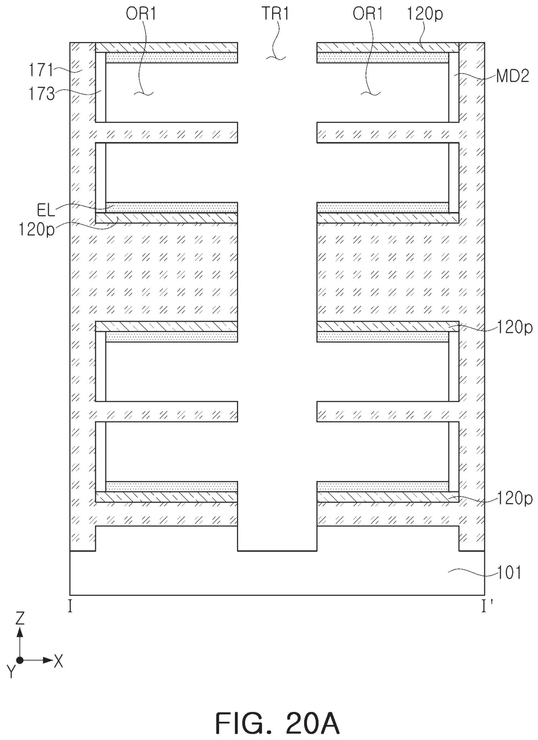

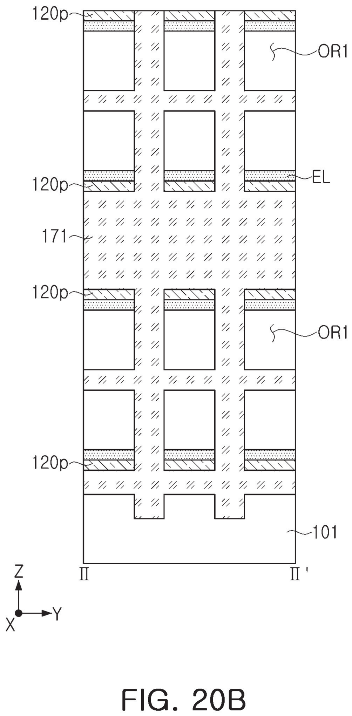

Referring to FIGS. 20A and 20B, an insulating material layer EL may be formed.

Using area selective deposition (ASD), the insulating material layer EL may be selectively deposited on the first channel material layer 120p exposed by the first open region OR1. The insulating material layer EL may include a high-κ material.

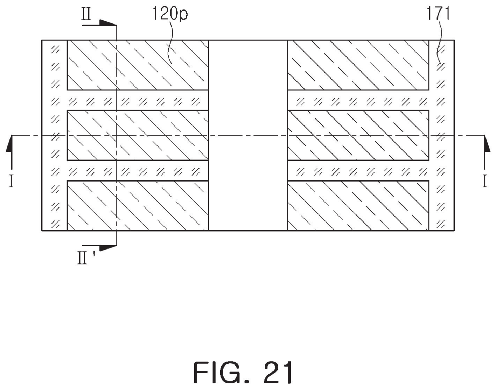

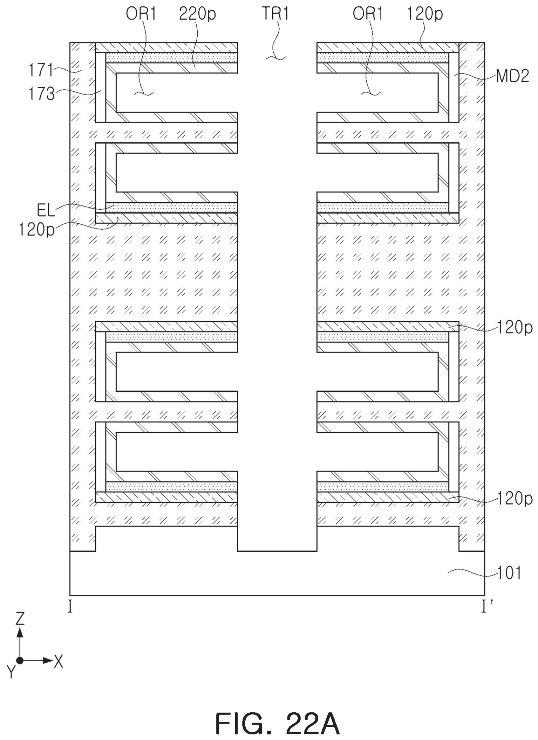

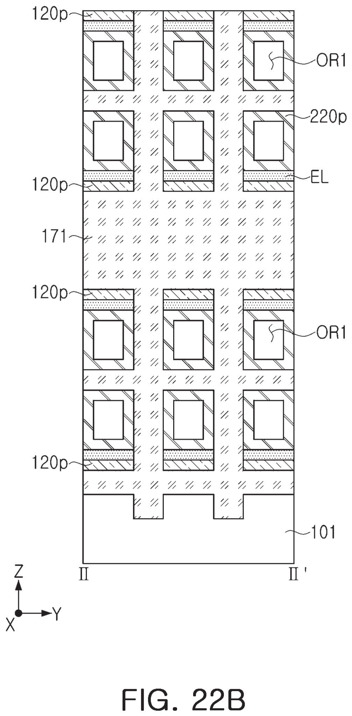

FIGS. 22A and 22B are vertical cross-sectional views taken along lines I-I' and II-II' of the memory cell area illustrated in FIG. 21.

Referring to FIGS. 21, 22A, and 22B, a second channel material layer 220p may be formed.

The second channel material layer 220p may be formed in the first open region OR1. Using an atomic layer deposition (ALD) technique, the second channel material layer 220p may be formed in the trench TR1 and the first open region OR1. The second channel material layer 220p may be formed on a surface of the insulating material layer EL, a surface of the insulating liner 173, and a surface of the mold insulating layer 171.

The second channel material layer 220p may include an oxide semiconductor. According to some example embodiments of the present inventive concepts, the second channel material layer 220p may include indium gallium zinc oxide (IGZO). However, example embodiments are not limited thereto.

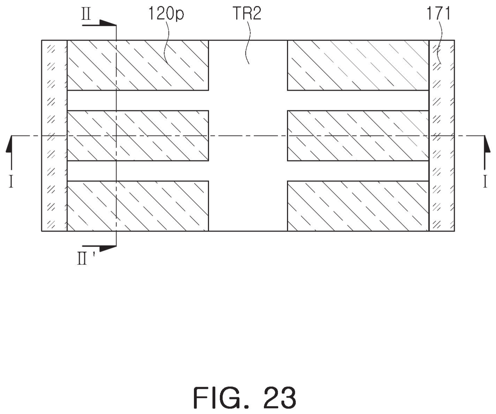

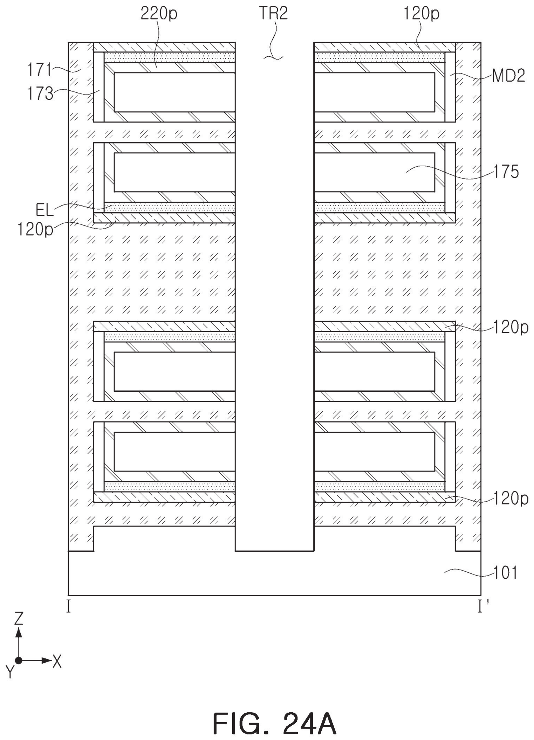

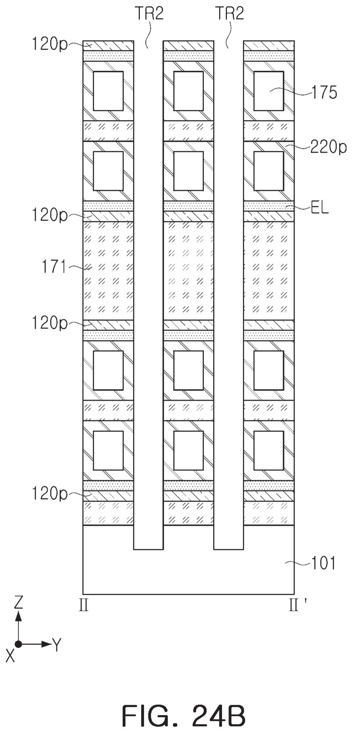

FIGS. 24A and 24B are vertical cross-sectional views taken along lines I-I' and II-II' of the memory cell area illustrated in FIG. 23.

Referring to FIGS. 23, 24A, and 24B, an insulating material may be filled in the first open region OR1 and the first trench TR1 of FIGS. 22A and 22B, thereby forming a mold insulating layer 175.

Referring to FIGS. 22A and 22B together, an insulating material may be filled in the first open region OR1. The insulating material may fill not only the first open region OR1 but also the first trench TR1. In this case, a second trench TR2 exposing the substrate 101 may be formed again.

The insulating material may include, for example, at least one of silicon oxide, silicon nitride, silicon oxynitride, or silicon oxycarbide. The mold insulating layer 175 may include, for example, silicon oxide. However, example embodiments are not limited thereto.

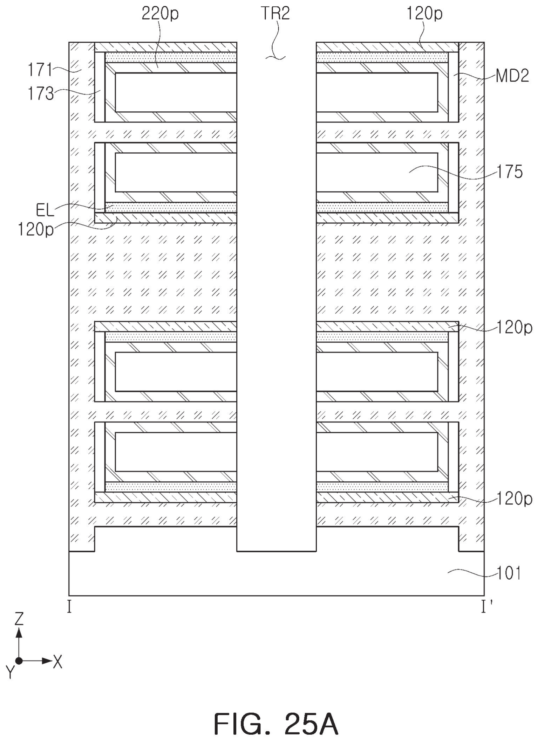

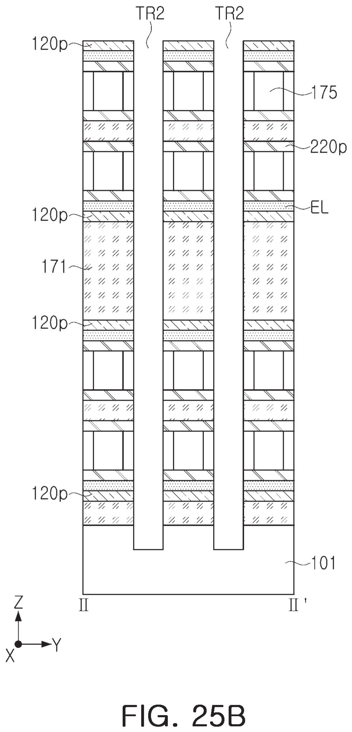

Referring to FIGS. 25A and 25B, a portion of the second channel material layer 220p may be removed.

The portion of the second channel material layer 220p extending in the vertical direction and spaced apart in the second horizontal direction (e.g., Y-direction) may be removed. Therefore, a surface of the mold insulating layer 175 may be exposed in the second horizontal direction (e.g., Y-direction).

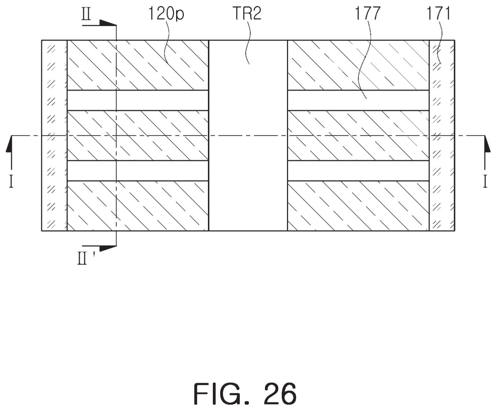

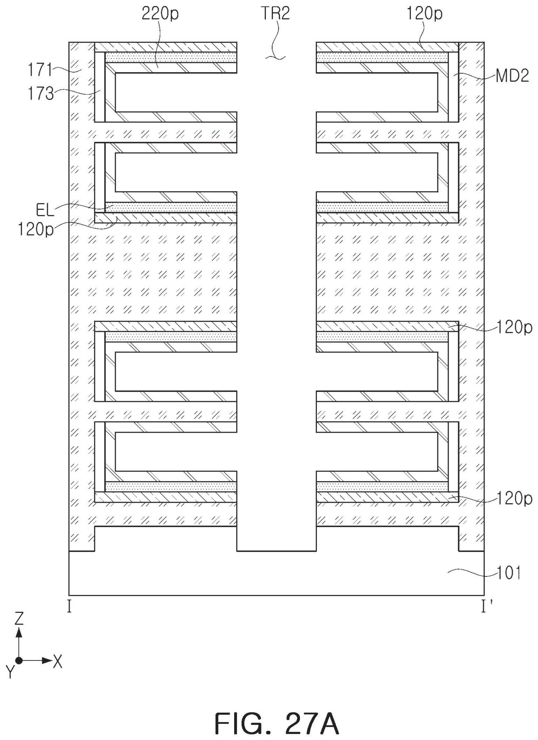

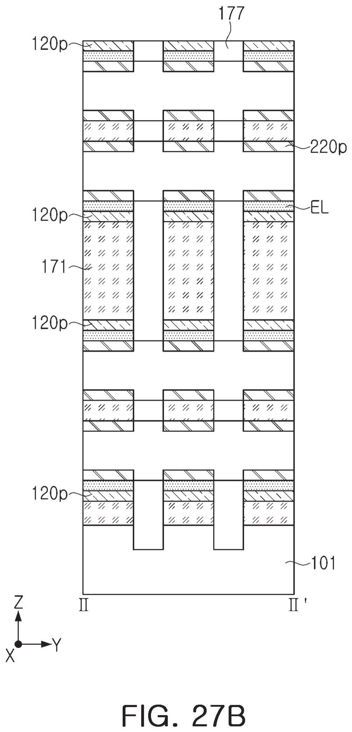

FIGS. 27A and 27B are vertical cross-sectional views taken along lines I-I' and II-II' of the memory cell area illustrated in FIG. 26.

Referring to FIGS. 26, 27A, and 27B, an insulating material may be filled in the second trench TR2 of FIGS. 25A and 25B, and a portion of the insulating material may be removed to form a mold insulating structure 177. In this case, the mold insulating layer 175 may be removed.

The insulating material may be filled in the second trench TR2, and a portion of the insulating material may be removed by an etching process in the lateral direction (e.g., in the X and/or Y-direction). Therefore, the mold insulating structure 177 may partially remain in a trench (see 'TR2' of FIG. 27B) extending in the second horizontal direction (e.g., in the Y-direction), among the second trenches TR2.

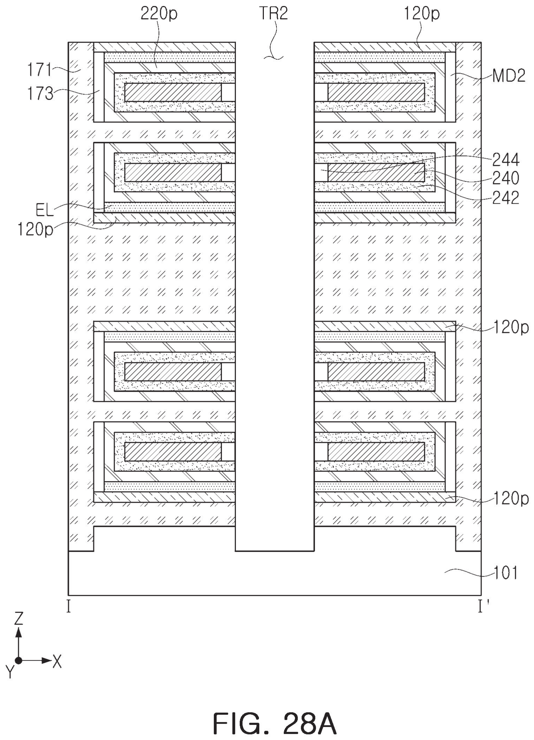

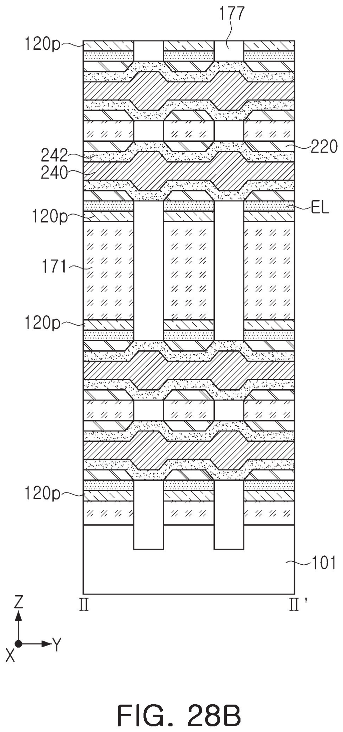

Referring to FIGS. 28A and 28B, a second gate dielectric layer 242, a second gate electrode layer 240, and a second gate capping layer 244 may be formed.

An insulating material may be deposited on the second channel material layer 220p to form the second gate dielectric layer 242. The second gate dielectric layer 242 may extend in the second horizontal direction (e.g., in the Y-direction).

A conductive material may be formed on the second gate dielectric layer 242 to form the second gate electrode layer 240. The second gate electrode layer 240 may extend in the second horizontal direction (e.g., Y-direction).

A portion of a side surface of the second gate dielectric layer 242 may be recessed and filled with an insulating material to form the second gate capping layer 244. The insulating material may include silicon oxide. The second gate dielectric layer 242 and the second gate electrode layer 240 may be defined as a second gate structure (GS2 of FIG. 3A).

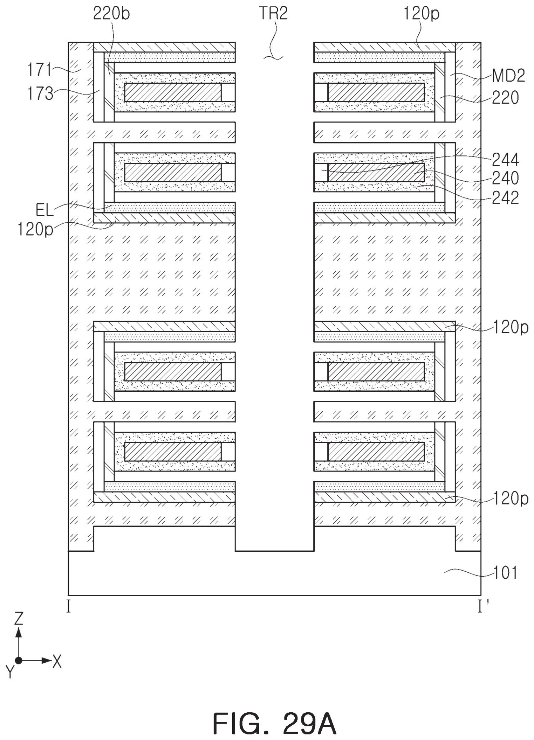

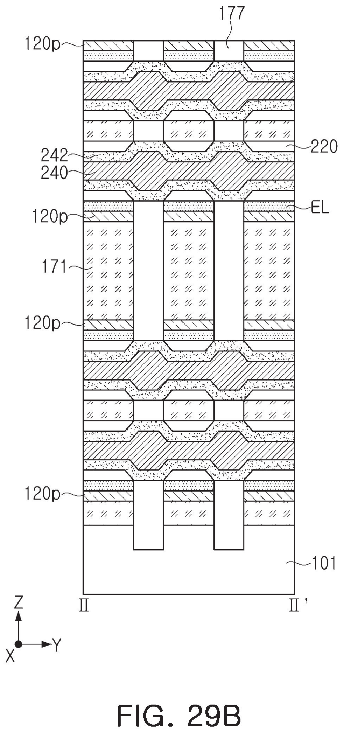

Referring to FIGS. 29A and 29B, a portion of the second channel material layer 220p of FIGS. 28A and 28B may be recessed and removed.

The portion of the second channel material layer 220p may be removed using an etching process in the lateral direction (e.g., X and Y-directions). Therefore, an inner surface of the insulating material layer EL may be exposed, and a vertical portion 220b of the second channel material layer 220p may remain.

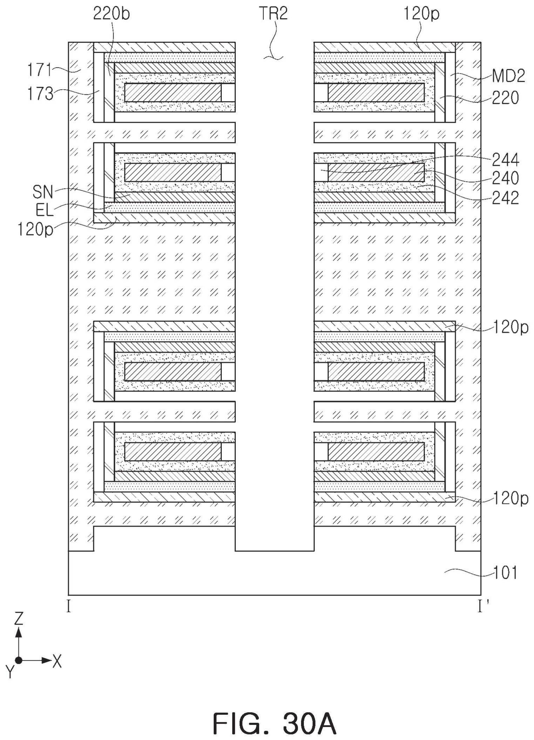

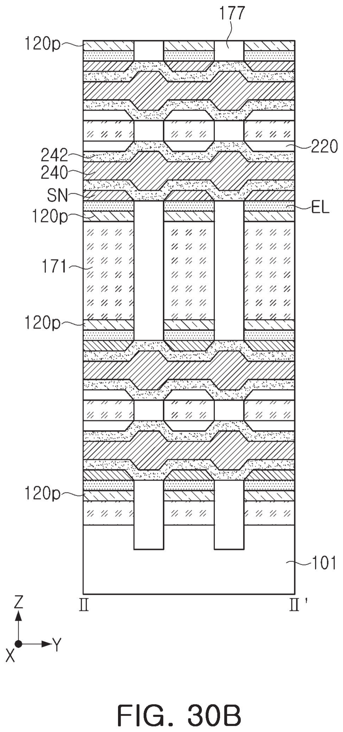

Referring to FIGS. 30A and 30B, a storage node SN may be formed.

Using area selective deposition (ASD), the storage node SN may be formed on the exposed inner surface of the insulating material layer EL. The storage node SN may include metal or a metal nitride. For example, the storage node SN may include titanium nitride, tungsten, ruthenium, molybdenum, or the like. However, example embodiments are not limited thereto.

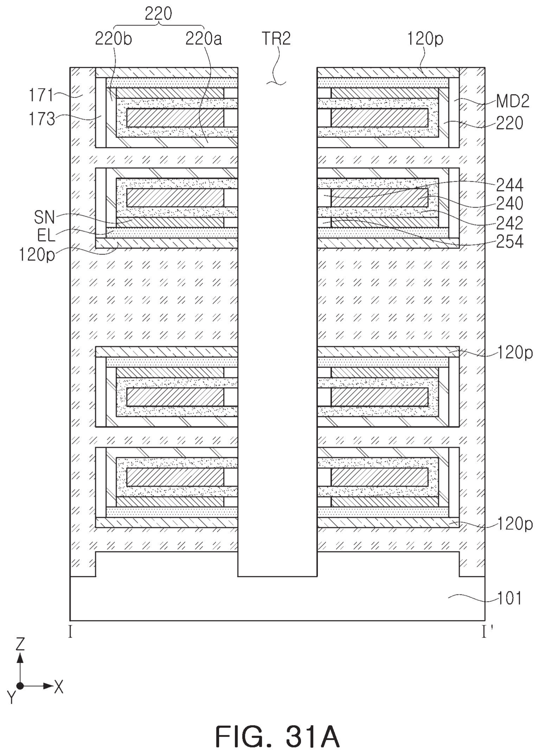

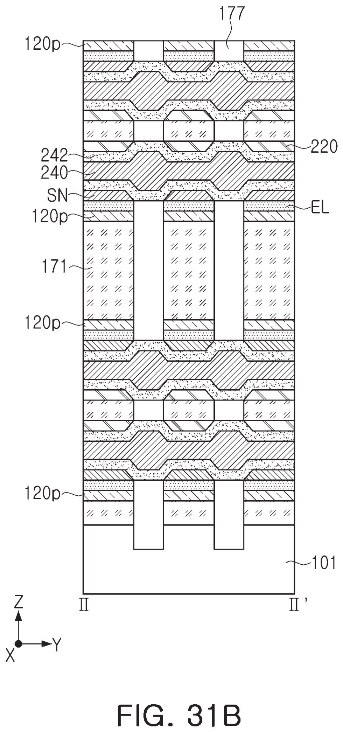

Referring to FIGS. 31A and 31B, a second channel material layer (or 'horizontal portion 220a') may be formed in an opposite side of the storage node SN, thereby forming a channel structure 220. Next, a portion of the side portion of the storage node SN may be recessed and filled with an insulating material to form an insulating capping layer 254.

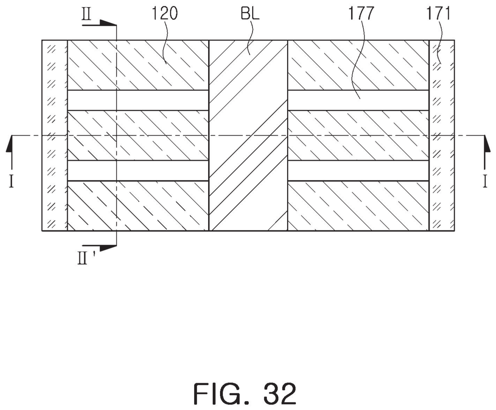

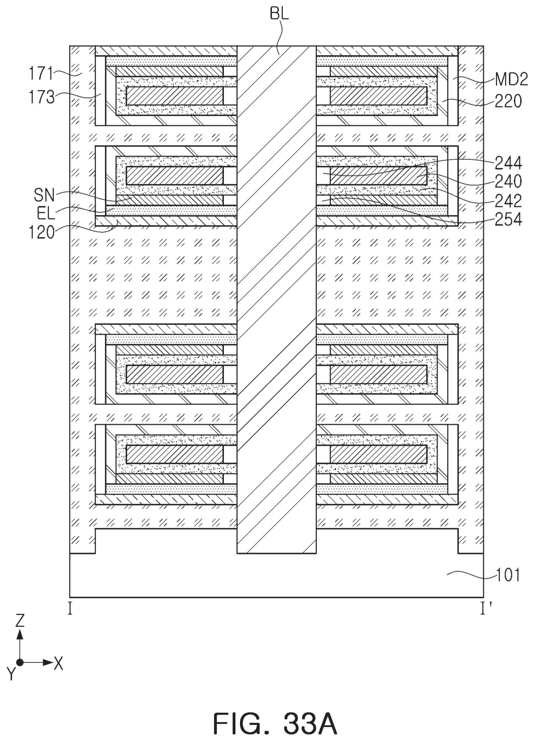

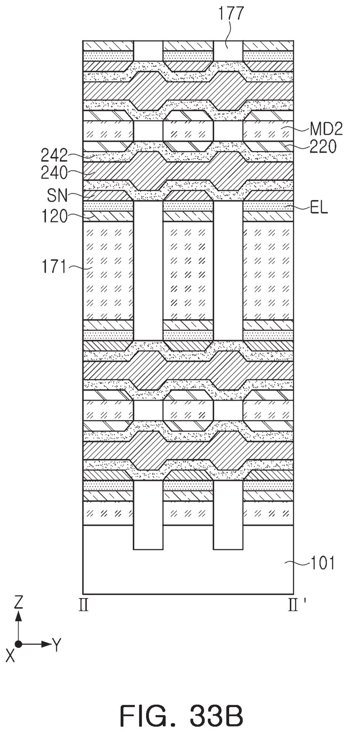

FIGS. 33A and 33B are vertical cross-sectional views along lines I-I' and II-II' of the memory cell area illustrated in FIG. 32.

Referring to FIGS. 32, 33A, and 33B, a bit line BL may be formed.

A conductive material may be filled in the second trench TR2 to form the bit line BL. The bit line BL may extend in the vertical direction, and may be spaced apart in the first horizontal direction (e.g., X-direction).

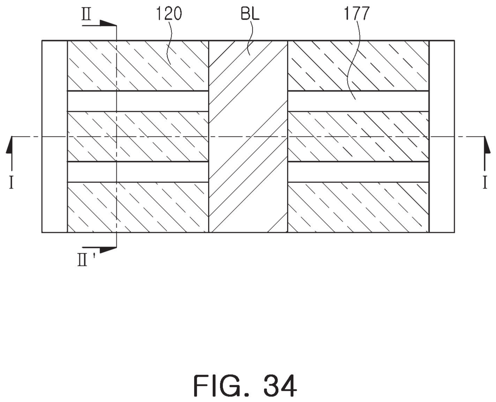

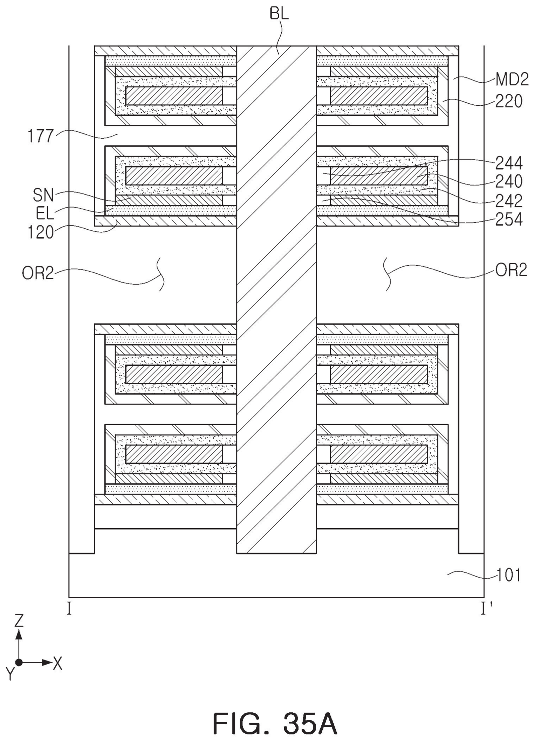

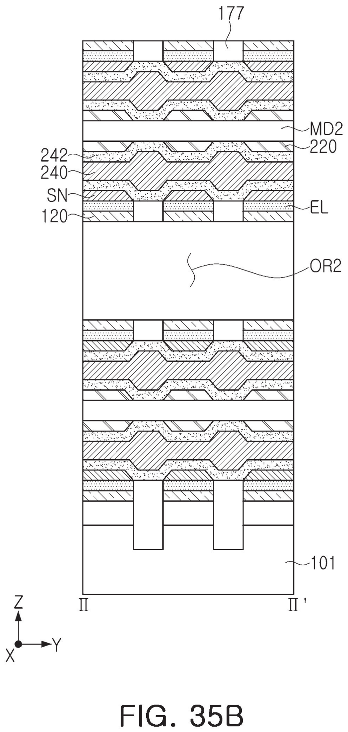

FIGS. 35A and 35B are vertical cross-sectional views along lines I-I' and II-II' of the memory cell area illustrated in FIG. 34.

Referring to FIGS. 34, 35A, and 35B, the mold insulating layer 171 may be removed, and an insulating structure 179 may be formed between vertically adjacent channel structures 220.

The mold insulation layer 171 may be removed, and a second open region OR2 may be defined. Thereafter, an insulation material may be deposited on the insulation liner 173, the first channel material layer 120p, and the bit line BL, to form an insulation liner. The insulation material may be filled between vertically adjacent channel structures 220. Thereafter, a portion of the insulation liner may be removed, to form the insulation structure 179.

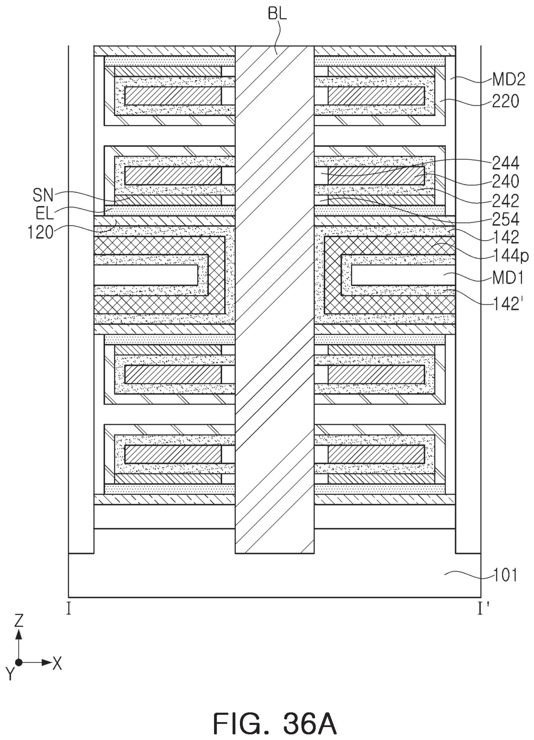

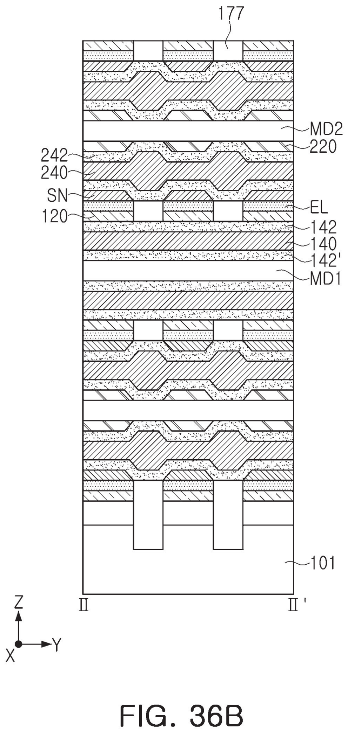

Referring to FIGS. 36A and 36B, a first gate dielectric layer 142, an insulation material layer 144p, an insulation liner 142', and a first mold insulation layer MD1 may be sequentially formed on a side portion of the bit line BL.

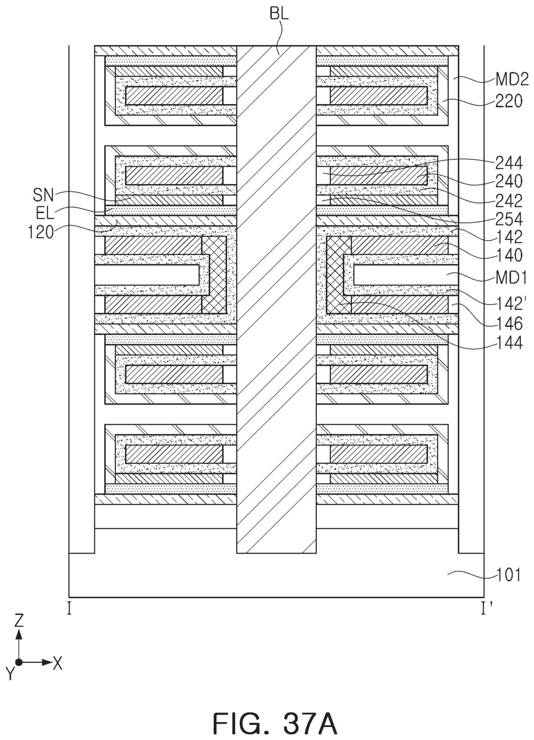

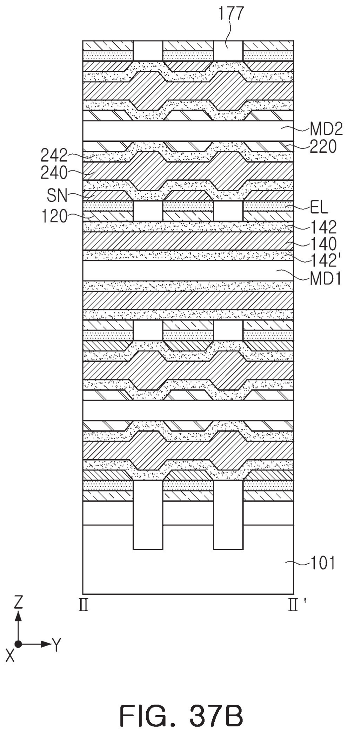

Referring to FIGS. 37A and 37B, a first gate electrode layer 140 and a second gate capping layer 146 may be formed.

A portion of the insulating material layer (144p of FIG. 36A) may be removed, and the removed portion may be filled with a conductive material to form the first gate electrode layer 140. Therefore, a first gate structure (GS1 of FIG. 3A) including the first gate electrode layer 140 and the first gate dielectric layer 142 may be defined in the second open region OR2 described with reference to FIGS. 35A and 35B. In addition, a first gate capping layer 144 may be defined as the portion of the insulating material layer is removed.

A portion of a side surface of the first gate electrode layer 140 may be recessed, and an insulating material may be filled to form the second gate capping layer 146. The insulating material may include silicon oxide. Thereafter, a plate electrode layer PP may be formed, and a semiconductor device 100 may be provided (see FIG. 3A).

According to some example embodiments of the present inventive concepts, a semiconductor device having improved reliability and a method for manufacturing the same may be provided.

Specifically, according to some example embodiments of the present inventive concepts, a semiconductor device including two-transistor (2T) memory cells respectively including a first transistor and a second transistor, may be provided.

More specifically, one of a first transistor or a second transistor may include a channel structure and a storage node connected to the channel structure, to provide a semiconductor device not including a separate capacitor.

According to some example embodiments of the present inventive concepts, a method for manufacturing a semiconductor device includes forming a substrate; and forming a plurality of memory cells respectively including a 2-transistor (2T) memory cell including a first transistor and a second transistor, and a bit line on the substrate, wherein the forming a plurality of memory cells and a bit line includes forming a first mold structure and a second mold structure on the substrate, wherein each of the first and second mold structures include a first sacrificial layer, a channel material layer, a second sacrificial layer, the channel material layer, the second sacrificial layer, the first sacrificial layer, the second sacrificial layer, and the channel material layer, sequentially stacked, removing the first sacrificial layer to fill a mold insulating layer, forming a first trench penetrating the first and second mold structures and the mold insulating layer, removing the second sacrificial layer to form a first open region, wherein the first open region extends from the first trench in a horizontal direction, forming the second transistor in the first open region, filling the first trench with a conductive material to form the bit line, removing the mold insulating layer to form a second open region, and forming the first transistor in the second open region, is provided.

In addition, the method in which the channel material layer includes silicon (Si), and the first and second sacrificial layers includes different materials, may be provided.

In addition, the method in which the channel material layer is exposed by the first open region, and, after the forming a first open region, further including forming an insulating material layer on the channel material layer exposed within the first open region, may be provided.

In addition, the method in which the forming a second open region includes forming a channel structure including a horizontal portion and a vertical portion within the first open region, forming a gate dielectric layer on the channel structure, and forming a gate electrode layer on the gate dielectric layer in sequence, may be provided.

In addition, the method in which the forming a channel structure includes depositing a first conductive material on an inner surface of the first open region to form a preliminary channel structure, after the forming a gate dielectric layer, recessing a portion of the preliminary channel structure extending in the horizontal direction to form a plurality of openings, and filling one of the plurality of openings with the first conductive material to form the horizontal portion of the channel structure, may be provided.

In addition, the method in which the first conductive material includes an oxide semiconductor, may be provided.

In addition, the method in which the forming the second transistor further includes, after the forming a horizontal portion of a channel structure, filling a remaining portion of the plurality of openings with a second conductive material to form a storage node, may be provided.

In addition, the method in which the storage node is in contact with the vertical portion of the channel structure, may be provided.

In addition, the method in which the second conductive material includes a metal material or an oxide semiconductor, may be provided.

In addition, the method in which the forming the first transistor by exposing the channel material layer by the second open region includes forming a gate dielectric layer on the channel material layer exposed within the second open region, and forming a gate electrode layer on the gate dielectric layer in sequence, may be provided.

According to some example embodiments of the present inventive concepts, a method of operating a semiconductor device including a 2-transistor (2T) memory cell, the 2-transistor (2T) memory cell comprising a first transistor and a second transistor on the first transistor and a storage node therebetween, the method comprising performing a write operation on a memory cell, the operation including applying a voltage to a gate electrode of the second transistor, flowing current through a channel structure of the second transistor, and accumulating or decreasing charges in the storage node between the first transistor and the second transistor.

In addition, in the performing the write operation on the memory cell, the write operation further comprising applying a lower voltage to a bitline connected to a first electrode of the second transistor during the write operation to decrease charges on the storage node, or applying a higher voltage to a bitline during the write operation to accumulate charges on the storage node.

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

Various advantages and effects of the present inventive concepts are not limited to the above-described contents, and will be more easily understood in the process of describing specific embodiments of the present inventive concepts.

While some example embodiments have been illustrated and described above, it will be apparent to those skilled in the art that modifications and variations could be made without departing from the scope of the present inventive concepts as defined by the appended claims.

## Claims

1. A semiconductor device comprising:
a bit line (BL) extending in a vertical direction (Z); and
a 2-transistor, 2T, memory cell (MC1, MC2) on at least one side of the bit line (BL), the 2-transistor, 2T, memory cell (MC1, MC2) including a first transistor (T1) and a second transistor (T2) on the first transistor (T1),
wherein
the first transistor (T1) includes
an active pattern (120) contacting the bit line (BL), the active pattern (120) including
a first source/drain region (SD1),
a second source/drain region (SD2), and
a channel region (CH) between the first source/drain region (SD1) and the second source/drain region (SD2), and
a first gate structure (GS1) including a first gate electrode layer (140; 140') overlapping at least a portion of the channel region (CH) of the active pattern (120), and the second transistor (T2) includes
a second gate structure (GS2) including a second gate electrode layer (240; 240'),
a channel structure (220) contacting the bit line (BL), the channel structure (220) including
a first horizontal portion (220a; 220a_1) extending in a first horizontal direction (X) away from the bit line (BL) from a portion in contact with the bit line (BL), and
a vertical portion (220b) extending vertically from one end of the first horizontal portion (220a; 220a_1), and
a storage node (SN; SN', SN") between the first gate electrode layer (140; 140') and the second gate electrode layer (240; 240'), and the storage node (SN; SN', SN") connected to the channel structure (220).

2. The semiconductor device of claim 1, wherein the storage node (SN; SN', SN") is in contact with the vertical portion (220b) of the channel structure (220).

3. The semiconductor device of claim 1 or 2, wherein an end portion of the storage node (SN") has a convex shape toward the vertical portion (220B) of the channel structure (220).

4. The semiconductor device of claim 1, wherein the channel structure (220) of the second transistor (T2) further includes a second horizontal portion (220a_2) connected to the vertical portion (220b) and extending in the first horizontal direction (X) toward the bit line (BL).

5. The semiconductor device of claim 4, wherein the storage node (SN) is in contact with the second horizontal portion (220a_2) of the channel structure (220).

6. The semiconductor device of claim 4 or 5, wherein the second horizontal portion (220a_2) of the channel structure (220) is on a level equal to a level of the storage node (SN).

7. The semiconductor device of any one of claims 1 to 6, wherein
the storage node (SN; SN', SN") includes a metal material or an oxide semiconductor, and
the channel structure (220) includes an oxide semiconductor.

8. The semiconductor device of any one of claims 1 to 7, wherein
the channel region (CH) of the active pattern (120) includes silicon, Si, and
the channel structure (220) includes an oxide semiconductor.

9. The semiconductor device of any one of claims 1 to 8, wherein
the storage node (SN; SN', SN") includes a first oxide semiconductor, and
the channel structure (220) includes a second oxide semiconductor having a carrier concentration different from a carrier concentration of the first oxide semiconductor.

10. The semiconductor device of any one of claims 1 to 9, wherein the first gate electrode layer (140; 140') extends on a same level in a second horizontal direction (Y), the second horizontal direction (Y) intersecting the first horizontal direction (X).

11. The semiconductor device of any one of claims 1 to 10, wherein the second gate electrode layer (240) includes:
a first portion (p1) vertically overlapping the storage node (SN); and
a second portion (p2) connected to the first portion (p1), the second portion (p2) having a thickness greater than a thickness of the first portion (p1).

12. The semiconductor device of any one of claims 1 to 11, further comprising:
a plate electrode layer (PP) opposite the bit line (BL) and contacting at least one of the first source/drain region (SD1) and the second source/drain region (SD2),
wherein the first gate structure (GS1) further includes
a first gate dielectric layer (142) between the active pattern (120) and the first gate electrode layer (140; 140'), and
a first gate capping layer (144) between the first gate electrode layer (140; 140') and the plate electrode layer (PP).

13. The semiconductor device of claim 12, wherein a side surface of a portion of the first gate electrode layer (140') adjacent to the plate electrode layer (PP) has a concave profile.

14. The semiconductor device of any one of claims 1 to 13, wherein the second gate structure (GS2) further includes:
a second gate dielectric layer (242) between the channel structure (220) and the second gate electrode layer (240; 240'), and the second gate dielectric layer (242) between the storage node (SN) and the second gate electrode layer (240; 240'); and
a second gate capping layer between the second gate electrode layer (240) and the bit line (BL).

15. The semiconductor device of claim 14, wherein a side surface of a portion of the second gate electrode layer (240') adjacent to the bit line (BL) has a concave profile.
